(19) Europäisches Patentamt
European Patent Office
Office européen des brevets

(11) **EP 2 169 715 B1**

(12) **EUROPÄISCHE PATENTSCHRIFT**

(45) Veröffentlichungstag und Bekanntmachung des Hinweises auf die Patenterteilung:
**22.04.2015  Patentblatt 2015/17**

(21) Anmeldenummer: **09154696.0**

(22) Anmeldetag: **10.10.2003**

(51) Int Cl.:
*H01L 49/02* (2006.01)    *H01L 27/12* (2006.01)
*H01L 21/8242* (2006.01)    *H01L 27/108* (2006.01)
*H01L 21/84* (2006.01)    *H01L 27/06* (2006.01)
*H01L 27/13* (2006.01)    *H01L 29/78* (2006.01)
*H01L 21/336* (2006.01)

(54) **Integrierte Schaltungsanordnung mit Kondensator und Herstellungsverfahren**

Integrated circuit with condenser and production method

Circuit intégré doté d'un condensateur et procédé de fabrication

(84) Benannte Vertragsstaaten:
**DE FR IT**

(30) Priorität: **18.10.2002   DE 10248722**

(43) Veröffentlichungstag der Anmeldung:
**31.03.2010   Patentblatt 2010/13**

(62) Dokumentnummer(n) der früheren Anmeldung(en) nach Art. 76 EPÜ:
**03757708.7 / 1 552 546**

(73) Patentinhaber: **Infineon Technologies AG**
**85579 Neubiberg (DE)**

(72) Erfinder:
• **Brederlow, Ralf**
**85586 Poing (DE)**
• **Schulz, Thomas**
**3001 Heverlee (BE)**
• **Rösner, Wolfgang, Dr.**
**85521 Ottobrunn (DE)**
• **Hartwich, Jessica, Dr.**
**01109 Dresden (DE)**
• **Pacha, Christian**
**81739 München (DE)**

(74) Vertreter: **Kindermann, Peter et al**
**Patentanwalte Kindermann**
**Postfach 10 02 34**
**85593 Baldham (DE)**

(56) Entgegenhaltungen:
EP-A2- 0 709 893       JP-A- H05 343 681
US-A1- 2002 125 536

**Beschreibung**

Die Erfindung betrifft eine integrierte Schaltungsanordnung, die einen elektrisch isolierenden Isolierbereich und mindestens einen Kondensator enthält. Der Kondensator wird aus einer Bereichsfolge gebildet, die in der angegebenen Reihenfolge enthält:

- einen isolierbereichsnahen Elektrodenbereich,
- einen dielektrischen Bereich, und
- einen isolierbereichsfernen Elektrodenbereich.

Der elektrisch isolierende Isolierbereich besteht beispielsweise aus einem elektrisch isolierenden Material mit einem spezifischen Widerstand größer als $10^{12}$ $\Omega$cm (Ohm mal Zentimeter) bei 20°C Raumtemperatur, z.B. aus einem Oxid, insbesondere Siliziumdioxid. Der Elektrodenbereich enthält beispielsweise ein Metall mit einem spezifischen elektrischen Widerstand kleiner als $10^{-4}$ $\Omega$cm bei 20°C Raumtemperatur. Alternativ enthalten die Elektrodenbereiche beispielsweise polykristallines Silizium, das hochdotiert ist. Der dielektrische Bereich besteht ebenfalls aus einem elektrisch isolierenden Material, z.B. aus einem Oxid, insbesondere Siliziumdioxid, das eine Dielektrizitätskonstante von etwa 3,9 hat. Jedoch werden auch dielektrische Materialien mit einer wesentlich größeren Dielektrizitätskonstante im dielektrischen Bereich verwendet.

Aus der EP 0 709 893 A2 sind eine Halbleiteranordnung, ein Signalkonverter und ein Signalbearbeitungssystem bekannt. Aus der US 2002/125536 A1 sind eine Halbleiteranordnung und ein zugehöriges Verfahren zur Herstellung bekannt. Aus der JP 05343681 ist eine Halbleiteranordnung bekannt.

Es ist Aufgabe der Erfindung, eine einfach herzustellende integrierte Schaltungsanordnung mit Kondensator anzugeben. Die Schaltungsanordnung soll insbesondere mit einer kleinen Anzahl von Prozessschritten und insbesondere unter Verwendung weniger lithografischer Masken herstellbar sein. Außerdem soll ein einfaches Herstellungsverfahren für eine integrierte Schaltungsanordnung mit Kondensator angegeben werden.

Die auf die Schaltungsanordnung bezogene Aufgabe wird durch eine integrierte Schaltungsanordnung mit den im Patentanspruch 1 angegebenen Merkmalen gelöst. Weiterbildungen sind in den Unteransprüchen angegeben.

Bei der erfindungsgemäßen Schaltungsanordnung ist der Isolierbereich Bestandteil einer in einer Ebene angeordneten Isolierschicht. Der Kondensator und mindestens ein aktives Bauelement der integrierten Schaltungsanordnung, vorzugsweise alle aktiven Bauelemente der integrierten Schaltungsanordnung, liegen auf der gleichen Seite der Isolierschicht. Außerdem sind der isolierbereichsnahe Elektrodenbereich und der aktive Bereich des Bauelementes in einer Ebene angeordnet, die parallel zu der Ebene liegt, in der die Isolierschicht angeordnet ist.

Die erfindungsgemäße Schaltungsanordnung ist einfach aufgebaut und lässt sich auf einfache Art herstellen, weil sich der isolierbereichsnahe Elektrodenbereich und der aktive Bereich in einer Ebene befinden. Außerdem ist der isolierbereichsnahe Elektrodenbereich und auch der aktive Bereich durch den Isolierbereich isoliert. An beide Elektrodenbereiche des Kondensators sind so frei wählbare Potentiale anlegbar.

Der Kondensator hat außerdem hervorragende elektronische Eigenschaften:

- Das Verhältnis zwischen parasitären Kapazitäten und Widerständen in Bezug zur Nutzkapazität ist klein, wobei unterschiedliche differentielle Kapazitäten auf Raumladungszonen zurückzuführen sind. Bei analogen Kapazitäten ist die differentielle Kapazität die im Arbeitspunkt wirksame Kapazität.
- die Leckströme sind klein,
- die differenzielle Nichtlinearität der Kapazität ist klein,
- die Kapazität ist über einen weiten Arbeitspunktbereich konstant,
- das erzielbare Kapazitäts-Flächen-Verhältnis ist groß, beispielsweise mehr als zehn Femtofarad je Quadratmikrometer oder sogar größer als zwanzig Femtofarad je Quadratmikrometer.

Außerdem ist zwischen den aktiven Bauelementen und dem Kondensator keine weitere Schicht oder weitere Schichtenfolge erforderlich. Dies ermöglicht es, die Anzahl der erforderlichen Schichten zu verringern und die Planarität der integrierten Schaltungsanordnung zu erhöhen.

Bei einer Weiterbildung sind der isolierbereichsnahe Elektrodenbereich und der aktive Bereich Halbleiterbereiche, die ein Halbleitermaterial enthalten, d.h. ein Material mit einem spezifischen elektrischen Widerstand zwischen $10^{-5}$ und $10^{+12}$ $\Omega$ cm, insbesondere zwischen $10^{-6}$ und $10^{+10}$ $\Omega$cm, z.B. Germanium, Silizium oder Galliumarsenid. Der spezifische Widerstand des isolierbereichsnahen Elektrodenbereiches des Kondensators wird bei einer Ausgestaltung durch eine Dotierung verringert.

Bei einer Weiterbildung der Schaltungsanordnung sind der isolierbereichsnahe Elektrodenbereich und der aktive Bereich einkristalline Bereiche, die ggf. dotiert sind. Die elektronischen Eigenschaften von aktiven Bauelementen in einkristallinen Schichten sind besonders gut. Außerdem lässt sich der elektrische Widerstand einer einkristallinen Elektrode des Kondensators durch Dotierung besonders gut verringern. Bei einer Ausgestaltung hat der isolierbereichsnahe Elektrodenbereich und auch der aktive Bereich eine Dicke kleiner als einhundert Nanometer oder sogar kleiner als fünfzig Nanometer. In solchen dünnen Halbleiterschichten lassen sich auf besonders einfache Art und Weise aktive Bauelemente erzeugen, die eine sehr kurze Kanallänge haben.

Bei einer nächsten Weiterbildung grenzt die Isolierschicht an ein Trägersubstrat an, wie es bei einem sogenannten SOI-Substrat (Silicon On Insulator) der Fall ist. Derartige Substrate lassen sich auf einfache Art und Weise herstellen. Außerdem haben die elektronischen Schaltungen, die auf diesen Substraten angeordnet werden, besonders gute elektronische Eigenschaften.

Bei der Erfindung sind der dielektrische Bereich und der isolierbereichsferne Elektrodenbereich an mindestens vier Seitenflächen des isolierbereichsnahen Elektrodenbereiches angeordnet. Durch diese Maßnahme lässt sich die Kapazität des Kondensators auf einfache Art erhöhen. Liegen die Seitenflächen quer zum Trägersubstrat, so wird für die Vergrößerung der Kapazität keine oder nur eine kleine zusätzliche Chipfläche benötigt. Eine weitere Maßnahme zum Vergrößern der Kapazität besteht darin, dass die Elektrodenbereiche eine Vielzahl von ineinandergreifenden Stegen enthalten. Die Steghöhe ist vorzugsweise größer als die Stegbreite.

Bei der Erfindung ist das aktive Bauelement ein Feldeffekttransistor:

- der Kanalbereich des Feldeffekttransistors ist der aktive Bereich. Ist der Kanalbereich undotiert, so ergeben sich insbesondere bei sehr kurzen Kanallängen von beispielsweise zehn Nanometern besonders gute elektronische Eigenschaften.
- Die Steuerelektrode des Feldeffekttransistors ist Bestandteil einer strukturierten Elektrodenschicht, in der auch der isolierbereichsferne Elektrodenbereich des Kondensators angeordnet ist. Die Steuerelektrode und der isolierbereichsferne Elektrodenbereich bestehen aus dem gleichen Material. Auch die Dicke dieser Bereiche und deren Dotierstoffkonzentration stimmen bei einer anderen Weiterbildung überein.
- Ein Steuerelektrodenisolationsbereich des Feldeffekttransistors besteht bei einer Ausgestaltung aus dem gleichen Material wie der dielektrische Bereich des Kondensators. Auch die Dicke dieser Bereiche stimmt überein.

Durch diese Maßnahme sind für die Herstellung des Kondensators und zur Herstellung des Feldeffekttransistors nur drei Schichterzeugungsprozesse erforderlich. Die Bereiche des Feldeffekttransistors und des Kondensators, die in der gleichen Schicht liegen, lassen sich gemeinsam strukturieren. Eine zusätzliche Maske zur Herstellung des Kondensators ist nur dann erforderlich, wenn der untere Elektrodenbereich des Kondensators anders dotiert wird als der Kanalbereich des Feldeffekttransistors. Eine weiter zusätzliche Maske ist nur dann erforderlich, wenn sich die Materialien und/oder die Isolierdicken des Steuerelektrodenisolierbereiches und des dielektrischen Bereiches des Kondensators unterscheiden. Aber selbst dann ist die zur Herstellung der Schaltungsanordnung erforderliche Anzahl der Masken noch klein.

Bei der Erfindung enthält der Feldeffekttransistor einen Steg bzw. eine Finne. An einander gegenüberliegenden Seiten des Steges sind Steuerelektroden angeordnet. Auf diese Weise entsteht ein Feldeffekttransistor mit hervorragenden Steuereigenschaften, beispielsweise ein sogenannter FinFET.

Bei der Erfindung gibt es einen Verbindungsbereich, der die Steuerelektroden elektrisch leitend verbindet. Bei der Erfindung ist der Verbindungsbereich vom Kanalbereich durch einen Isolierbereich getrennt, dessen Isolierstärke größer ist als die Isolierstärke des Steuerelektrodenisolierbereiches. Durch diese Maßnahmen lassen sich Kanteneffekte bei der Steuerung des Transistors vermeiden.

Bei einer anderen Ausgestaltung grenzt die Steuerelektrode an einen Silizidbereich an. Durch diese Maßnahme lässt sich die Steuerelektrode leichter kontaktieren. Außerdem verringert sich der Anschlusswiderstand und der Schichtwiderstand.

Bei einer nächsten Weiterbildung der erfindungsgemäßen Schaltungsanordnung grenzen Anschlussbereiche des Feldeffekttransistors an die Isolierschicht. Bei einer Ausgestaltung grenzen die Anschlussbereiche ebenfalls an Silizidbereiche. Ausreichend Material für die Silizidbildung ist dann vorhanden, wenn die Halbleiterschicht im Bereich der Anschlussbereiche sowohl vor als auch nach der Silizidbildung eine größere Dicke hat als im Bereich der isolierbereichsnahen Elektrode.

Bei einer nächsten Weiterbildung sind beidseitig der Steuerelektroden Abstandshalter angeordnet, die auch ein anderes Material enthalten oder aus einem anderen Material bestehen als die Elektrodenschicht, insbesondere einem Material, das nicht als Ausgangspunkt für ein Epitaxieschichtwachstum bei einem Epitaxieverfahren zum Erzeugen einer Halbleiterepitaxieschicht geeignet ist, beispielsweise aus Siliziumnitrid. Durch die Verwendung der Abstandshalter werden Seitenbereiche der Steuerelektrode bedeckt, so dass von dort keine Epitaxie ausgehen kann und Kurzschlüsse vermieden werden.

Bei einer Ausgestaltung ist an mindestens einer Seite des isolationsbereichsfernen Elektrodenbereiches ebenfalls ein Abstandshalter angeordnet. Die Abstandshalter haben die gleiche Aufgabe wie die an der Steuerelektrode angeordneten Abstandshalter erfüllt. Berühren sich ein am Gate angeordneter Abstandshalter und ein an einer Elektrode angeordneter Abstandshalter, so entsteht eine Maskierung, die bspw. eine Dotierung oder auch eine Silizidierung im maskierten Bereich verhindert.

Bei einer nächsten Weiterbildung grenzen ein Anschlussbereich des Feldeffekttransistors und der isolierbereichsnahe Elektrodenbereich des Kondensators aneinander und bilden so eine elektrisch leitfähige Verbindung. Auf diese Art und Weise entsteht eine einfach aufgebaute Speicherzelle eines DRAM (Dynamic Random Access Memory), ohne dass zusätzliche Maßnahmen für die Kontaktierung der isolierbereichsnahen Elektrode erforderlich sind.

Bei einer Weiterbildung ist die an den einen Anschlussbereich des Transistors angrenzende Seite des isolierbereichsnahen Elektrodenbereiches länger als eine quer zu dieser Seite liegende Seite des isolierbereichsnahen Elektrodenbereiches, vorzugsweise mindestens doppelt so lang oder mindestens fünf mal so lang. Der Transistor hat in diesem Fall eine Transistorweite, die ein mehrfaches der minimalen Strukturbreite beträgt, vorzugsweise mehr als das Dreifache oder mehr als das Fünffache. Durch diese Maßnahmen entsteht eine besonders niederohmige Verbindung zwischen dem Transistor und dem Kondensator. Dies führt insbesondere bei sogenannten analogen Kapazitäten in analogen Schaltungen zur Verbesserung der elektronischen Eigenschaften. Beispiele für solche analogen Schaltungen sind Analog-Digital-Wandler. Ein anderes Beispiel für eine analoge Kapazität ist eine sogenannte Bypass-Kapazität mit der sich Spannungsspitzen auf eine Betriebsspannungsleitung oder einer Signalleitung glätten lassen.

Bei einer alternativen Weiterbildung ist dagegen eine quer zu der an den Anschlussbereich angrenzende Seite des isolierbereichsnahen Elektrodenbereiches liegende Seite des isolierbereichsnahen Elektrodenbereiches länger als die an den Anschlussbereich angrenzende Seite, vorzugsweise mindestens doppelt so lang oder mindestens fünf mal so lang. Der Transistor hat in diesem Fall eine Transistorweite, die kleiner als das Dreifache der minimalen Strukturbreite ist, vorzugsweise kleiner als das Doppelte der minimalen Strukturbreite. Durch diese Maßnahme wird insbesondere bei Speicherzellen erreicht, dass sich der ohmsche Widerstand der Bodenelektrode des Kondensators erhöht und einer schnellen Entladung der Speicherkapazität damit entgegengewirkt wird.

Bei einer anderen Weiterbildung enthält die Schaltungsanordnung mindestens einen Prozessor, der eine Vielzahl von logischen Schaltfunktionen enthält. Enthält die Schaltungsanordnung bei einer Ausgestaltung neben dem Prozessor außerdem eine Vielzahl von DRAM-Speichereinheiten (Dynamic Random Access Memory), so wird auch von einem embedded-Speicher gesprochen. Zur Herstellung dieser Schaltungsanordnung werden zusätzlich zu den für die Herstellung der Logik ohnehin erforderlichen Prozessschritten und Masken nur eine kleine Anzahl von zusätzlichen Prozessschritten und zusätzlichen Masken zur Herstellung des Kondensators bzw. der mit ihm elektrisch leitfähig verbundenen Transistoren benötigt.

Die Erfindung betrifft in einem weiteren Aspekt außerdem ein Verfahren nach Anspruch 16 zum Herstellen einer integrierten Schaltungsanordnung, insbesondere zum Herstellen der erfindungsgemäßen Schaltungsanordnung oder einer ihrer Weiterbildungen. Bei dem erfindungsgemäßen Verfahren werden u.a. die folgenden Verfahrensschritte ausgeführt:

- Bereitstellen eines Substrats, das eine Isolierschicht aus elektrisch isolierendem Material und eine Halbleiterschicht enthält, z.B. ein SOI-Substrat,
- Strukturieren der Halbleiterschicht zum Ausbilden mindestens eines Elektrodenbereiches für einen Kondensator und zum Ausbilden mindestens eines aktiven Bereiches eines Transistors,
- nach dem Strukturieren der Halbleiterschicht Erzeugen einer dielektrischen Schicht,
- nach dem Erzeugen der dielektrischen Schicht Erzeugen einer Elektrodenschicht, und
- Ausbilden einer isolierbereichsfernen Elektrode des Kondensators und einer Steuerelektrode des Transistors in der Elektrodenschicht.

Das erfindungsgemäße Verfahren ist besonders geeignet zur Herstellung eines sogenannten FinFET gemeinsam mit dem Kondensator. Die oben genannten technischen Wirkungen der erfindungsgemäßen Schaltungsanordnung und ihrer Weiterbildungen gelten auch für das erfindungsgemäße Verfahren und dessen Weiterbildungen.

Im Folgenden werden Ausführungsbeispiele der Erfindung an Hand der beiliegenden Zeichnungen erläutert. Darin zeigen:

Figuren 1A bis 16B    Herstellungsstufen bei der Herstellung einer integrierten DRAM-Speicherzelle,

Figur 17    eine Draufsicht auf die Speicherzelle, und

Figur 18    eine Draufsicht auf eine DRAM-Speicherzelle mit drei Transistoren.

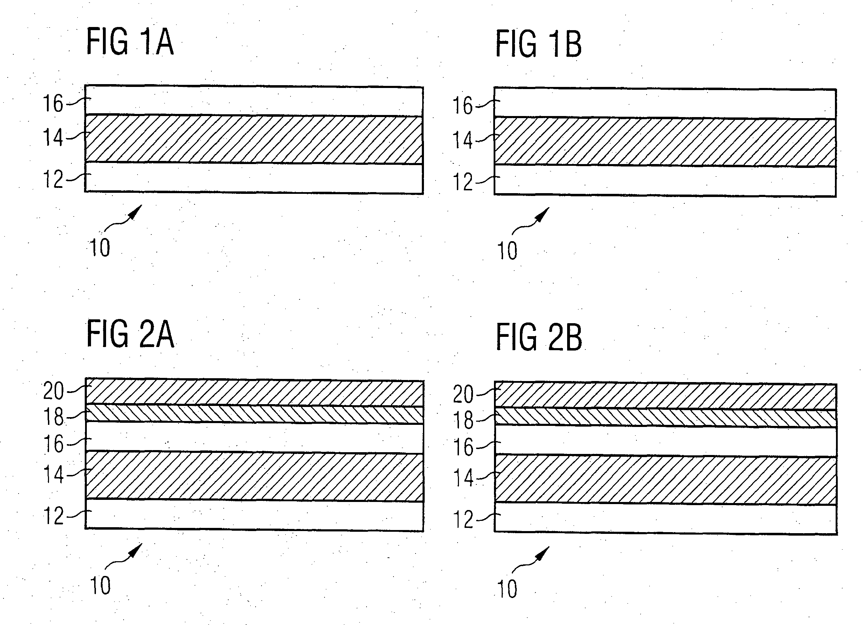

Die Figuren 1A bis 16B zeigen Herstellungsstufen bei der Herstellung einer integrierten Speicherzelle, wobei die Figuren 1A bis 16A einen Schnitt entlang einer Schnittebene I betreffen, die längs zu einem Kanal eines Feldeffekttransistors liegt, insbesondere längs zur Stromflussrichtung im Kanal. Die Figuren 1B bis 16B betreffen jeweils den Schnitt entlang einer Schnittebene II, die quer zum Kanal liegt.

Die Herstellung der Speicherzelle beginnt ausgehend von einem SOI-Substrat 10, das ein Trägersubstrat 12 aus einkristallinem Silizium, eine sogenannte vergrabene Isolierschicht 14 aus beispielsweise Siliziumdioxid und eine dünne Halbleiterschicht 16 aus monokristallinem Silizium enthält. Im Ausführungsbeispiel betragen die Dicke des Trägersubstrats 12 fünfhundertfünfzig Mikrometer, die Dicke der Isolierschicht 14 einhundert Nanometer und die Dicke der Halbleiterschicht 16 fünfzig Nanometer. Bei der in Figur 1A dargestellten Herstellungsstufe gibt es noch keine Unterschiede entlang der Schnittebene I bzw. II, siehe Figur 1B.

Wie in den Figuren 2A und 2B dargestellt, wird auf das SOI-Substrat 10 anschließend eine Siliziumnitridschicht 18 abgeschieden, beispielsweise mit Hilfe eines CVD-Verfahrens (Chemical Vapor Deposition). Im Ausführungsbeispiel hat die Siliziumnitridschicht 18 eine Dicke von fünfzig Nanometern. Über die Siliziumnitridschicht 18 wird dann ganzflächig eine Siliziumdioxidschicht abgeschieden, z.B. eine TEOS-Schicht 20 (Tetra-Ethyl-Ortho-Silicate) mit Hilfe eines TEOS-Verfahrens. Im Ausführungsbeispiel hat die TEOS-Schicht 20 eine Dicke von fünfundsiebzig Nanometern. Entlang der Schnittebenen I und II liegen noch gleiche Verhältnisse vor, siehe Figur 2B.

Bei einem anderen Ausführungsbeispiel wird die Doppelschicht aus der Siliziumnitridschicht 18 und der TEOS-Schicht 20 durch eine einzige Schicht ersetzt. Dadurch ergibt sich eine Prozessvereinfachung.

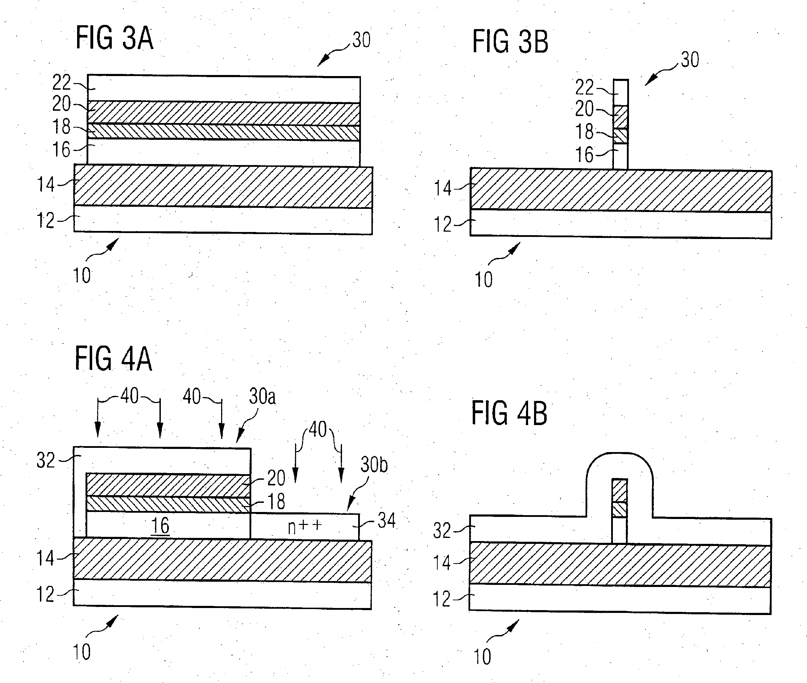

Wie in den Figuren 3A und 3B dargestellt, wird anschließend ein Lithografieverfahren durchgeführt. Dazu wird ein Fotolack 22 ganzflächig aufgebracht, gemäß einem vorgegebenen Layout belichtet und entwickelt. Anschließend werden die TEOS-Schicht 20, die Nitridschicht 18 und die Halbleiterschicht 16 strukturiert, beispielsweise mit einem Trockenätzverfahren. Dabei entsteht ein Schichtstapel 30 bzw. Mesa, der sich im Bereich der Schnittebene II zu einem Stegbereich verjüngt, siehe Figur 3B, und dann wieder aufweitet. Die Geometrie für den herzustellenden Feldeffekttransistor und den Kondensator lassen sich unabhängig voneinander vorgeben und somit optimieren.

Der Fotolack 22 wird anschließend entfernt. Alternativ zu einem fotolithografischen Verfahren wird bei einem anderen Ausführungsbeispiel ein Elektronenstrahl-LithografieVerfahren oder ein anderes geeignetes Verfahren durchgeführt.

Wie in den Figuren 4A und 4B dargestellt, wird anschließend ein weiteres Fotolithografieverfahren ausgeführt, bei dem eine zusätzliche Maske zur Herstellung des Kondensators erforderlich ist. Es wird eine Fotolackschicht 32 aufgebracht, mit der Maske belichtet, entwickelt und strukturiert. Bei der Strukturierung werden die TEOS-Schicht 20 und die Siliziumnitridschicht 18 oberhalb eines Bodenelektrodenbereiches 34 in der Halbleiterschicht 16 entfernt. Dadurch wird der Stapel 30 in einen Transistorteil 30a und in einen Kondensatorteil 30b aufgeteilt.

Anschließend wird unter Verwendung der strukturierten Fotolackschicht 32 eine Ionenimplantation durchgeführt, wobei der Bodenelektrodenbereich 34 stark n-dotiert wird, in Figur 4A dargestellt durch n$^{++}$ und durch Implantationspfeile 40. In dem für den Transistor vorgesehenen Bereich wird die Halbleiterschicht 16 nicht dotiert. Durch die Zusatzimplantation wird der Bodenelektrodenbereich 34 niederohmig. Beispielsweise beträgt die Dotierungsdichte $10^{20}$ Dotieratome je Kubikzentimeter. Die Dotierungsdicht liegt vorzugsweise im Bereich zwischen $10^{19}$ bis $10^{21}$ Dotieratome je Kubikzentimeter. Bei steigender Dotierdichte wächst das Dielektrikum schneller als auf undotierten oder nur mittel stark dotierten Bereichen. Jedoch werden mit steigender Dotierungsdichte die sich ausbildenden Raumladungszonen kleiner, so dass parasitäre Effekte ebenfalls kleiner werden.

Das spätere Kanalgebiet des Transistors, insbesondere die Seitenflächen dieses Kanalgebietes, werden durch die Fotolackschicht 32 geschützt, so dass in diese Bereiche keine Ionen vordringen, die eine Dotierung bewirken könnten.

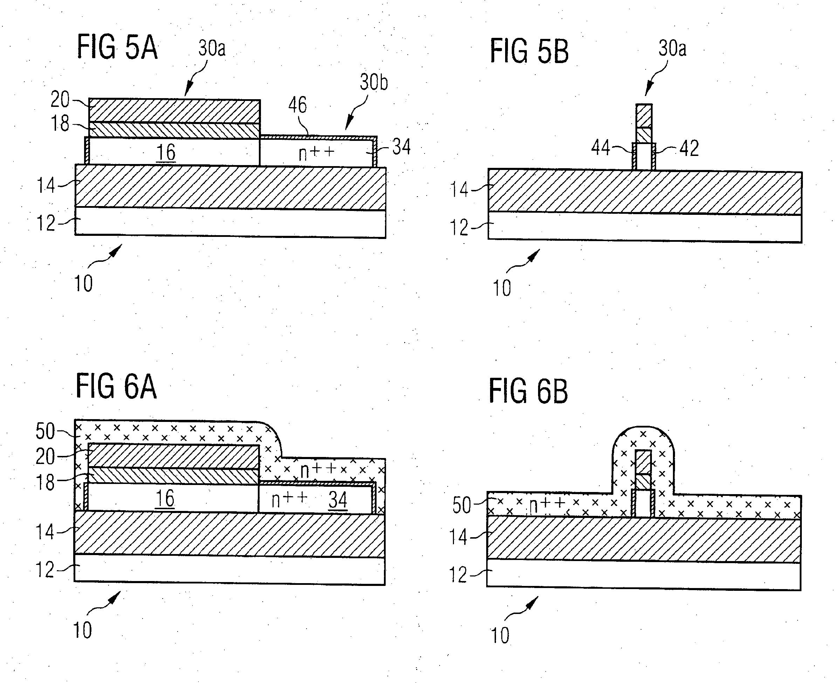

Wie in den Figuren 5A und 5B dargestellt, wird anschließend die Fotolackschicht 32 entfernt. An allen freiliegenden Seiten der Halbleiterschicht 16 und insbesondere auch an den freiliegenden Seiten des Bodenelektrodenbereiches 34 wird anschließend eine dünne Oxidschicht erzeugt, die im Bereich des Transistors das Gateoxid 42 bzw. 44 und im Bereich des Kondensators ein Dielektrikum 46 bildet. Beispielsweise wächst die Oxidschicht thermisch auf. Im Ausführungsbeispiel hat die Oxidschicht im Bereich des undotierten Siliziums eine Dicke von zwei Nanometern.

Bei einem alternativen Ausführungsbeispiel wird unter Verwendung eines weiteren Lithografieverfahrens im Bereich des Kondensators ein Dielektrikum aus einem anderen Material und/oder ein Dielektrikum mit einer anderen Dicke als in dem für den Transistor vorgesehenen Bereich erzeugt.

Wie in den Figuren 6A und 6B dargestellt, wird anschließend in-situ oder nachträglich dotiertes polykristallines Silizium abgeschieden, wobei eine Polysiliziumschicht 50 erzeugt wird. Die Polysiliziumschicht 50 hat beispielsweise eine Dicke von einhundert Nanometern und eine Dotierstoffkonzentration von $10^{21}$ Dotieratomen je Kubikzentimeter. Die starke Dotierung vom n-Leistungstyp ist wiederum durch das Symbol n$^{++}$ dargestellt. Als Dotieratome werden beispielsweise Phosphoratome verwendet.

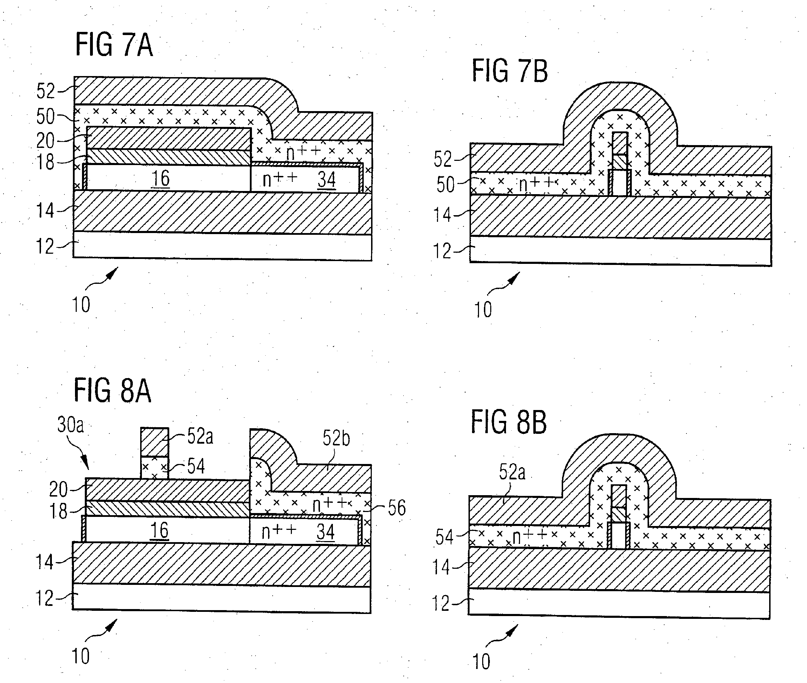

Wie in den Figuren 7A und 7B gezeigt, wird anschließend auf die Polysiliziumschicht 50 eine weitere TEOS-Schicht 52 abgeschieden, die dicker ist als die TEOS-Schicht 20. Im Ausführungsbeispiel beträgt die Dicke der TEOS-Schicht 52 einhundert Nanometer.

Die TEOS-Schicht 52 hat eine Doppelfunktion. Wie weiter unten noch erläutert, dient die TEOS-Schicht 52 zunächst als Hartmaske für die Strukturierung der Steuerelektrode (Gate) des Transistors. Danach dient die TEOS-Schicht 52 als Implantationsmaske, die ein nochmaliges Dotieren der Gateelektrode verhindert. Auf diese Weise ist es möglich, Gateelektrode und Source-/Drain-Bereiche unterschiedlich zu dotieren. Damit lässt sich die Gateelektrodenaustrittsarbeit frei wählen.

Wie in den Figuren 8A und 8B gezeigt, wird anschließend ein weiteres Lithografieverfahren zur Strukturierung einer Gateelektrode 54 durchgeführt. Dazu wird wiederum eine in den Figuren nicht dargestellte Fotolackschicht aufgebracht, belichtet und entwickelt. Anschließend werden die TEOS-Schicht 52 und die Polysiliziumschicht 50 strukturiert, beispielsweise geätzt. Dabei entsteht im Bereich des Transistors die Gateelektrode 54 und im Bereich des Kondensators eine Deckelektrode 56. Die Gateelektrode 54 wird durch einen TEOS-Schichtbereich 52a bedeckt. Die Deckelektrode 56 wird durch einen TEOS-Schichtbereich 52b bedeckt. Die Ätzung stoppt auf der TEOS-Schicht 20. Bei der Ätzung der Polysiliziumschicht 50 wird deutlich überätzt, damit sämtliche parasitären Polysilizium-Abstandshalter an den Seitenwänden des Schichtstapels 30a entfernt werden. Die Seitenwände sind nach der Ätzung nur durch die dünne Oxidschicht bedeckt.

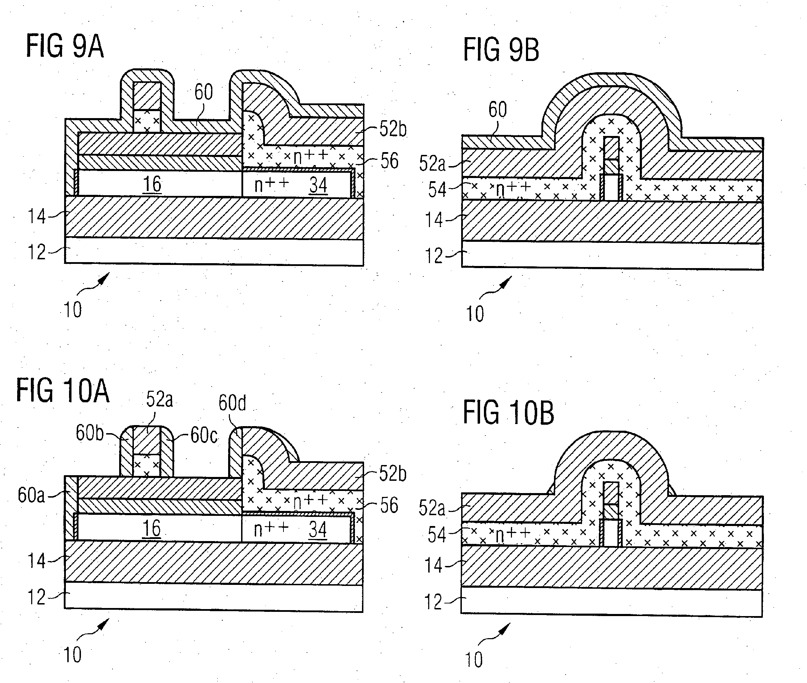

Wie in den Figuren 9A und 9B gezeigt, wird anschließend eine dünne Siliziumnitridschicht 60 ganzflächig abgeschieden, beispielsweise mit Hilfe eines CVD-Verfahrens. Die Siliziumnitridschicht 60 hat im Ausführungsbeispiel eine Dicke von fünfzig Nanometern.

Wie in den Figuren 10A und 10B dargestellt, wird die Siliziumnitridschicht 60 anschließend in einem anisotropen Ätzprozess zu Abstandshaltern 60a an den Seitenwänden des Transistorteils 30a, Abstandshaltern 60b, 60c an den Seitenwänden der Gateelektrode 54 und des TEOS-Schichtbereiches 52a sowie zu einem Abstandshalter 60d an den Seitenwänden der Deckelektrode 56 und des TEOS-Bereiches 52b zurückgeätzt.

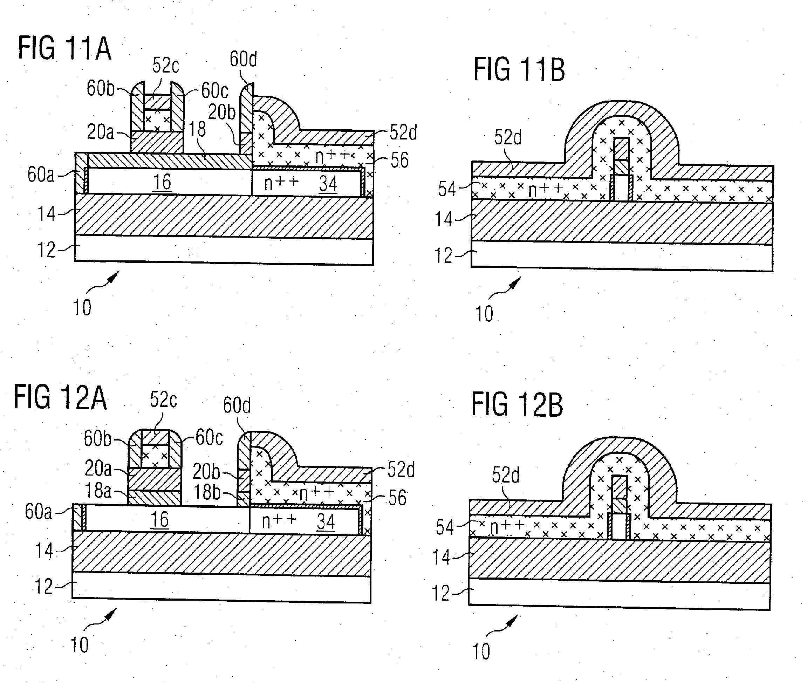

Wie in den Figuren 11A und 11B dargestellt, wird danach die dünne TEOS-Schicht 20 ohne Verwendung eines Lithografieverfahrens geätzt, d.h. selbstjustierend, beispielsweise mit einem RIE-Verfahren (Reactive Ion Etching). Es entsteht unterhalb der Abstandshalter 60b, 60c und unterhalb der Gateelektrode 54 ein TEOS-Schichtbereich 20a. Unterhalb des Abstandshalters 60d entsteht ein TEOS-Schichtbereich 20b. Während des Ätzens werden auch die TEOS-Schichtbereiche 52a und 52b gedünnt, bspw. auf fünfundzwanzig Nanometer. Es entstehen gedünnte TEOS-Schichtbereiche 52c oberhalb der Gateelektrode 54 und 52d oberhalb der Deckelektrode 56. Durch die Ätzung wird außerdem die Siliziumnitridschicht 18 in Breichen freigelegt, die nicht vom TEOS-Schichtbereich 20a bedeckt sind. Die Abstandshalter 60a bis 60d werden durch die Ätzung der TEOS-Schicht 52 nicht angegriffen, so dass sie etwas über die gedünnten TEOS-Schichtbereiche 52c und 52d hinausstehen.

Wie in den Figuren 12A und 12B gezeigt, wird anschließend die Nitridschicht 18 selbstjustierend strukturiert, wobei freiliegende Bereiche dieser Siliziumnitridschicht 18 entfernt werden. Unterhalb des TEOS-Schichtbereiches 20a verbleibt ein Nitridschichtbereich 18a. Unterhalb des TEOS-Schichtbereiches 20b verbleibt ein Nitridschichtbereich 18b. Beispielsweise wird mit einem RIE-Verfahren (Reactive Ion Etching) geätzt. Dabei werden auch die Abstandshalter 60a bis 60d gekürzt. Die Schichtdicken und Ätzungen sind so dimensioniert, dass die Gateelektrode 54 nach der Ätzung der Siliziumnitridschicht 18 immer noch an den Seiten von den Abstandshaltern 60b und 60c umgeben ist. Von oben wird die Gateelektrode 54 weiterhin durch eine ausreichend dicke TEOS-Schicht maskiert, beispielsweise eine TEOS-Schicht 52c mit einer Dicke von fünfundzwanzig Nanometern. Die Source-/Drain-Gebiete liegen nach dem Ätzen der Siliziumnitridschicht 18 offen.

Die Abstandshalter 60b und 60c schließen nun mit der oberen Oberfläche des TEOS-Bereiches 52c ab. Der Abstandshalter 60d schließt mit der oberen Oberfläche des TEOS-Schichtbereiches 52d ab.

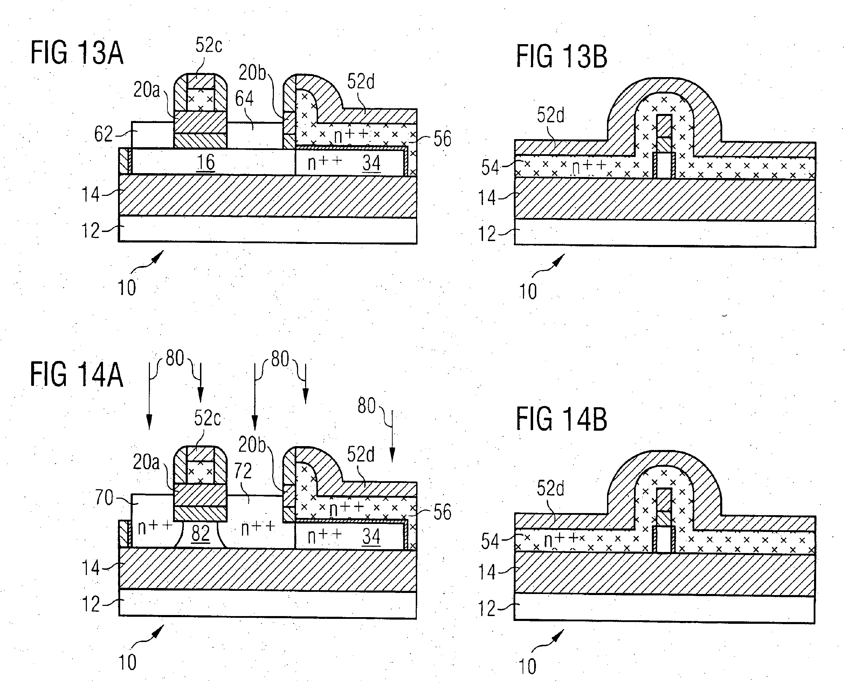

Wie in den Figuren 13A und 13B dargestellt, wird anschließend ein selektives Epitaxieverfahren durchgeführt. Eine monokristalline Epitaxieschicht wächst nur auf den freigelegten Source-/Drain-Bereichen der Halbleiterschicht 16 auf. Es entstehen Epitaxiebereiche 62 und 64 auf monokristallinem Silizium. Die Epitaxiebereiche 62 und 64 erstrecken sich etwa bis zur halben Höhe der TEOS-Schichtbereiche 20a bzw. 20b.

Die Epitaxiebereiche 62 und 64 werden auch als "angehobene" (elevated) Source-/Drain-Bereiche bezeichnet. Die Dicke der Epitaxieschicht für die Epitaxiebereiche 62 und 64 richtet sich vor allem nach der Dicke der Halbleiterschicht 16 und der nachfolgend erläuterten Silizidierung. Bei der Silizidierung wird vorhandenes Silizium verbraucht, so dass entsprechend viel Silizium für die Reaktion bereitgestellt wird. Durch diese Maßnahme wird ein "Abreißen" der Kanalanschlüsse im Bereich des Drain-/Source-Bereiches vermieden.

Wie in den Figuren 14A und 14B gezeigt, wird nach dem Epitaxieverfahren eine Ionenimplantation, z.B. n++, d.h. stark n-dotiert, zum Herstellen der hochdotierten Source-/Drain-Bereiche 70 und 72 durchgeführt, siehe Implantationspfeile 80. Eine Maske ist hier lediglich zum Trennen von Bereichen mit komplementären Transistoren in einem CMOS-Prozess (Complementary Metal Oxide Semiconductor) erforderlich. Durch die Implantation werden die Epitaxiebereiche 62, 64 und die darunterliegenden Bereiche der Halbleiterschicht 16 niederohmig n++ dotiert. Außerdem wird dabei eine Verbindung zwischen dem Source-/Drain-Bereich 72 und dem Bodenelektrodenbereich 34 des Kondensators hergestellt. Ein zwischen den Source-/Drain-Bereichen 70 und 72 in der Halbleiterschicht 16 liegender Kanalbereich 82 bleibt undotiert.

Während der Implantation dienen die TEOS-Schichtbereiche 52c und 52d als Implantationsmaske. Die Dotierungen der Gateelektrode 54 und der Deckelektrode 56 werden deshalb bei der Implantation nicht verändert.

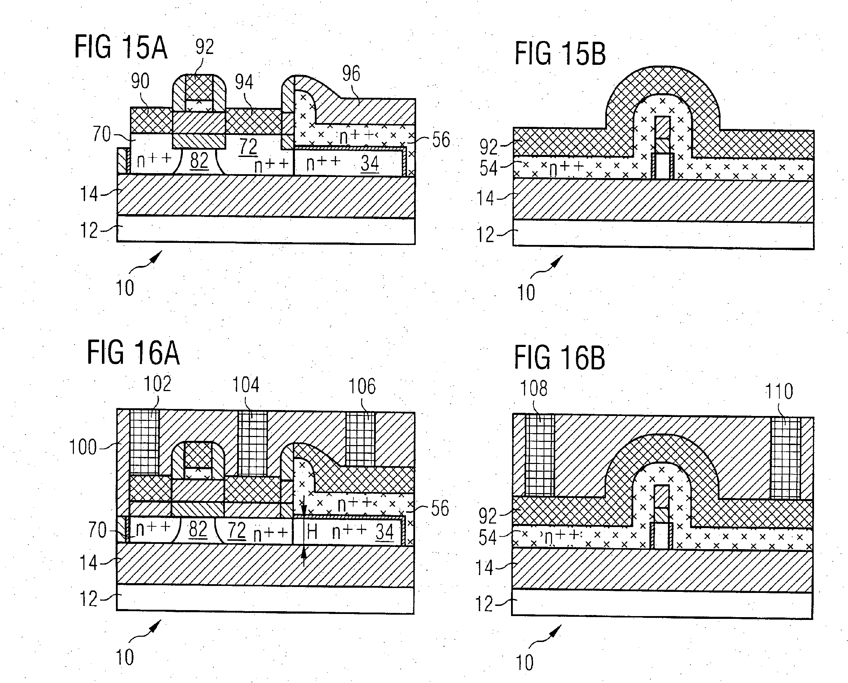

Wie in den Figuren 15A und 15B dargestellt, werden im Anschluss an die HDD-Implantation (High Density Drain) die Reste der TEOS-Schicht 52, d.h. insbesondere die TEOS-Schichtbereiche 52c und 52d weggeätzt. Anschließend wird ein Salicide-Verfahren (Self aligned silicide) durchgeführt. Dazu wird beispielsweise ganzflächig eine Nickelschicht abgeschieden. Bei Temperaturen von beispielsweise 500°C bildet sich Nickelsilizid auf den Epitaxiebereichen 62, 64, auf der Gateelektrode 54 und auf der Deckelektrode 56, siehe Silizidbereiche 90 bis 96. An Stelle von Nickel lässt sich auch ein anderes Metall mit einer Schmelztemperatur über 1400 Grad Celsius verwenden, insbesondere ein Refraktärmetall, um bspw. Titansilizid oder Kobaltsilizid herzustellen.

Wie in den Figuren 16A und 16B dargestellt, wird anschließend eine Passivierungsschicht 100 aufgebracht, beispielsweise aus Siliziumdioxid. In die Passivierungsschicht 100 werden Kontaktlöcher geätzt und beispielsweise mit Wolfram gefüllt, wobei Verbindungsabschnitte 102, 104, 106, 108 und 110 entstehen, die in dieser Reihenfolge zum Silizidbereich 90, 94, 96 bzw. 92 führen. An Stelle der beiden zum Silizidbereich 92 führenden Verbindungsabschnitte 108 und 110 wird bei einem anderen Ausführungsbeispiel nur ein Verbindungsabschnitt vorgesehen. Die Verbindungsabschnitte 102 bis 110 werden anschließend noch mit Leiterbahnen einer Metallisierungslage oder mehrerer Metallisierungslagen verbunden. Dabei wird ein konventioneller CMOS-Prozess ausgeführt, der auch als "Back End" bezeichnet wird.

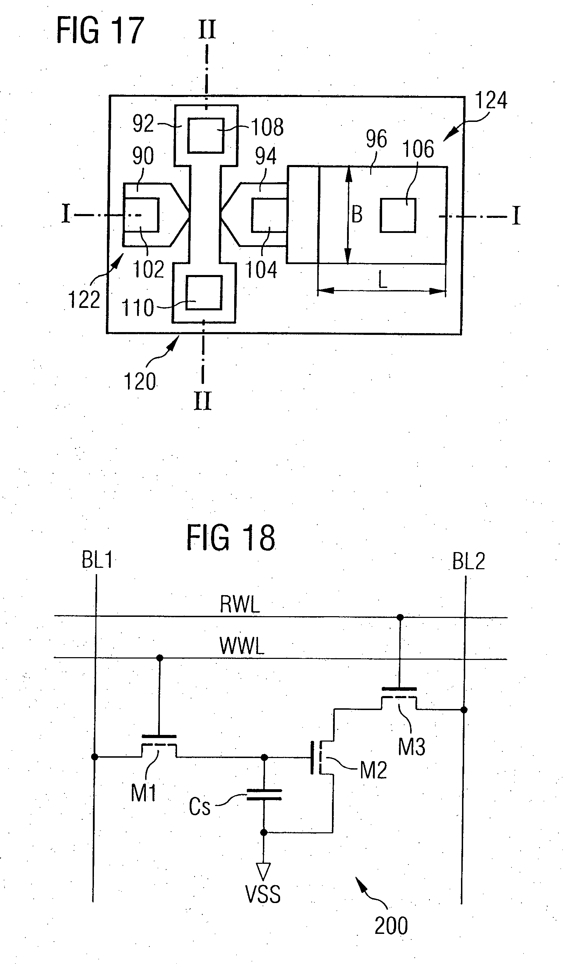

Figur 17 zeigt eine Draufsicht auf die Speicherzelle 120, die einen FinFET 122 und einen Kondensator 124 enthält. Der Kondensator 124 ist im Verhältnis zu dem Transistor 122 in allen Figuren 1A bis 17 verkleinert dargestellt.

Als effektiv wirksame Fläche des Kondensators 124 ergibt sich:

$$A = L \cdot B + H \cdot (2 \cdot L + B),$$

wobei A die wirksame Fläche, B die Breite des Kondensators, L die Länge des Kondensators, H die in Figur 16A eingetragene Höhe des Bodenelektrodenbereiches 34 sind.

Ein bevorzugter Anwendungsbereich einer solchen embedded DRAM-Kapazität ist der Ersatz von mittelgroßen SRAM-Speichereinheiten durch einen schnellen embedded-DRAM, beispielsweise im zweiten und dritten Zugriffsniveau einer Mikroprozessorspeicherhierarchie, d.h. im second and third level cache. Beispielsweise hat bisher eine SRAM-Speicherzelle eine Fläche von 134 $F^2$, wobei F die minimale Strukturgröße ist. Wird beispielsweise ein Dielektrikum mit einer Dielektrizitätskonstante $\varepsilon r$ gleich fünfundzwanzig eingesetzt, z.B. Tantalpentoxid, so lässt sich eine typische embedded-DRAM-Kapazität CMEM von zwanzig Femtofarad pro Speicherzelle gemäß den folgenden Berechnungen realisieren. Die Oxidkapazität beträgt:

$$COX = \varepsilon r \ \varepsilon 0/tphys = 110 \ fF/\mu m^2,$$

wobei tphys die Oxiddicke ist, die im Ausführungsbeispiel zwei Nanometer beträgt. Es ergibt sich eine erforderliche Fläche AMEM der Speicherkapazität von:

$$AMEM = CMEM/COX = 0,18 \ \mu m^2.$$

Für eine minimale Strukturbreite F gleich fünfzig Nanometer entspricht dies 72 $F^2$ für die Kapazität. Diese Fläche lässt sich beispielsweise mit einem quaderförmigen Bodenelektrodenbereich 34 erzeugen, der eine Grundfläche von L · B = 8 F · 6 F hat, wobei die Höhe H gleich 1 F beträgt. Dies entspricht einer Flächenreduktion um dreiunddreißig Prozent bezogen auf einen planaren SOI-Prozess. Für höhere Höhen H steigt dieser Flächengewinn. Einschließlich des Zugangstransistors ergibt sich eine Gesamtfläche der FinFET-Kapazitätsanordnung von 68 $F^2$, wobei der FinFET 122 mit einem Gatekontakt ausgeführt wird. Die Fläche der embedded-DRAM-Speicherzelle liegt damit unter der SRAM-Zellgröße von 134 $F^2$.

Bei der Erfindung wird eine Kapazität in die FET-Ebene also in das sogenannte top-Silizium auf einem SOI-Substrat integriert. Im Unterschied zu SOI-CMOS-Technologien mit planaren, vollständig verarmten SOI-Transistoren wird jedoch ein FinFET eingesetzt, der aufgrund der beiden Steuerkanäle an den Seitenwänden bessere Steuereigenschaften hat. Zur Herstellung der SOI-Kapazität ist nur ein zusätzlicher Prozessschritt erforderlich, wenn das besonders hochqualitative Gatedielektrikum des Transistors als Dielektrikum des Kondensators genutzt wird.

Bei einer effektiven Oxiddicke von einem Nanometer, einer Korrektur von 0,8 Nanometern für die Gate- und top-Silizium-Verarmung und aufgrund der quantenmechanischen Effekte ergibt sich eine Kapazität pro Fläche von:

$$COX = 3,9 \ \varepsilon 0/tfox = 19 \ fF/\mu m^2,$$

wobei tfox gleich 1,8 Nanometer die elektrisch wirksame Oxiddicke und $\varepsilon 0$ die Dielektrizitätskonstante im Vakuum bezeichnen. Bei der Verwendung eines Metall-Gates verringert sich die elektrisch wirksame Oxiddicke um etwa 0,4 Nanometer aufgrund der nicht mehr vorhandenen Gate-Verarmung, wodurch sich die Kapazität pro Fläche erhöht auf:

$$COX = 3,9\ \varepsilon 0/tfox = 24\ fF/\mu m^2.$$

Die erfindungsgemäßen Kapazitäten werden auch als sogenannte Bypass-Kapazitäten zur Dämpfung von sogenannten Spikes und zur Dämpfung von Übersprechen in der Spannungsversorgung der integrierten Schaltungsanordnung verwendet. Auch als analoge Kapazitäten sind sie bestens geeignet, insbesondere in Oszillatoren oder Analog-Digital-Wandlern. Auch für sogenannte Mixed-Signal Schaltungen werden die Kapazitäten eingesetzt, d.h. für Schaltungen mit analogen Kapazitäten und bspw. Speicherkapazitäten in Speicherzellen.

Bei anderen Ausführungsbeispielen wird an Stelle des Gateoxids ein gesondertes high-K-DRAM-Dielektrikum mit $\varepsilon r$ größer einhundert eingesetzt. Beispielsweise ein Dielektrikum, das Bariumstrontiumtitanat (BST) oder Epitaxie-Bariumstrontiumtitanat enthält. Dadurch verringert sich der Flächenbedarf auf ca. 22 $F^2$. Mit Hilfe einer zweiten Zusatzmaske wird der Bereich für das high-K-Dielektrikum auf den SOI-Stapeln festgelegt.

Als weitere Vorteile gegenüber bisherigen Technologiekonzepten ergibt sich ein planarer Übergang zwischen reinen Logikblöcken und embedded-DRAM-Blöcken. Weiterhin werden tiefe Vias und Kontakte vermieden.

Der geringe Leckstrom in FinFET-Transistoren sowie die geringeren Parasitärkapazitäten, die den Anteil der Nutzkapazität an der Gesamtkapazität erhöhen, führen zudem zu einer weiteren verringerten embedded-DRAM-Kapazität von CMEM gleich zehn Femtofarad.

Bei dem an Hand der Figuren 1A bis 17 erläuterten Ausführungsbeispiel wurde keine LDD-Dotierung (Lightly Doped Drain) durchgeführt. Bei einem anderen Ausführungsbeispiel wird zusätzlich zu der HDD-Dotierung auch eine LDD-Dotierung durchgeführt.

Bei einem weiteren Ausführungsbeispiel werden ein Transistor und der Kondensator räumlich weiter voneinander entfernt angeordnet und jeweils mit eigenen Verbindungsabschnitten verbunden.

Insbesondere bei DRAM-Speicherzellen (dynamic random access memory) mit nur einem Transistor ist der Verbindungsabschnitt 104 nicht erforderlich. Die Abstandshalter 60c und 60d können sich dann berühren, so dass sie als Maske bei der Dotierung des Anschlussbereiches 70 und bei der selektiven Silizidierung dienen. Unter den Abstandshaltern 60c und 60d bildet sich dann ein Anschlussbereich durch Ausdiffusion von Dotieratomen aus dem Bodenelektrodenbereich 34.

Figur 18 zeigt einen Schaltplan einer DRAM-Speicherzelle 200 dynamic random access memory) mit drei Transistoren M1 bis M2 sowie mit einem Kondensator Cs, die mit dem an Hand der Figuren 1A bis 16A erläuterten Verfahrensschritten hergestellt worden sind. Beispielsweise ist der in Figur 17 dargestellte Transistor 122 in einem ersten Fall der Transistor M1. Der Kondensator 124 ist dann der Kondensator Cs. Im ersten Fall führt eine elektrisch leitende Verbindung von einer an den Bodenelektrodenbereich 34 angrenzenden zusätzlichen Anschlussfläche in der Halbleiterschicht 16 oder vom Verbindungsabschnitt 104 zu dem Gate des Transistors M2.

Alternativ wird in einem zweiten Fall das Layout jedoch so gewählt, dass der Transistor 122 dem Transistor M2 entspricht, wobei der Kondensator 124 wieder dem Kondensator Cs entspricht. Im zweiten Fall ist die Deckelektrode 56 elektrisch leitend mit dem einen Anschlussbereich des Transistors M1 und mit dem Gate des Transistors M2 verbunden.

Die Schaltung der Speicherzelle 200 enthält eine Teilschaltung zum Schreiben und eine Teilschaltung zum Lesen, wobei beim Lesen die Ladung des Kondensators Cs nicht verändert wird, so dass auch ein Auffrischen dieser Ladung nach einem Lesevorgang nicht erforderlich ist.

Die Teilschaltung zum Schreiben enthält den Schreib-Transistor M1 und den Kondensator Cs. Der Gateanschluss des Transistors M1 ist mit einer Schreibwortleitung WWL verbunden. Der Sourceanschluss des Transistors M1 ist mit einer Schreibbitleitung BL1 verbunden. Bei einer Schaltungsanordnung mit besonders guten elektrischen Eigenschaften gemäß dem oben erwähnten ersten Fall führt der Drainanschluss des Transistors M1 zu einem Speicherknoten X, der durch die Bodenelektrode 34 des Kondensators 124 gebildet wird. Die Deckelektrode 56 des Kondensators Cs liegt auf einem Massepotential VSS. Bei der Alternative gemäß dem zweiten Fall führt der Drainanschluss des Transistors M1 zu einem Speicherknoten X, der durch die Deckelektrode 56 des Kondensators 124 gebildet wird. Die Bodenelektrode 34 des Kondensators Cs liegt auf einem Massepotential VSS.

Die Teilschaltung zum Lesen enthält die Transistoren M2 und M3. Der Gateanschluss des Transistors M3 ist mit einer Lesewortleitung RWL verbunden. Der Drainanschluss des Transistors M3 ist mit einer Lesebitleitung BL2 verbunden, die vor Beginn des Lesevorganges bspw. auf ein Betriebspotential VDD aufgeladen wird. Der Sourceanschluss des Transistors M3 ist mit dem einen Drainanschluss des Transistors M2 verbunden. Der Gateanschluss des Transistors M2 ist mit dem Speicherknoten X verbunden. Der Sourceanschluss des Transistors M2 liegt auf dem Massepotential VSS.

Der Transistor M2 übernimmt die Aufgabe eines Verstärkers, so dass auch bei Ladungsverlusten auf dem Speicherknoten X noch ein zuverlässiges Lesen möglich ist. Befindet sich eine positive Ladung auf dem Speicherknoten X, so ist der Transistor M2 im eingeschalteten Zustand und die vorgeladene Lesebitleitung BL2 wird beim Lesevorgang entladen.

Da die Gate-Source-Kapazität des Transistors M2 parallel zum Kondensator Cs liegt, erhöht sich die effektiv wirksame Speicherkapazität Ceff:

$$Ceff = Cs + CGS(M2),$$

wobei Cs die Kapazität des Kondensators Cs und CGS die Gate-Source-Kapazität des Transistors M2 sind. Auf Grund des Herstellungsverfahrens sind die Kapazitäten pro Fläche des Speicher-Kondensators Cs und des Transistors M2 bspw. gleich groß, wenn das Gateoxid und das Kondensatordielektrikum in derselben dielektrischen Schicht erzeugt werden und die Schicht überall die gleiche Schichtdicke hat.

Der Flächenbedarf der Speicherzelle 200 wird durch die Anforderungen an die effektiv wirksame Speicherkapazität Ceff bestimmt. Bei geringen Leckströmen und einer hohen Transistorverstärkung, die einen hohen Lesestrom zur Folge hat, lässt sich der Speicher-Kondensator Cs verkleinern. Die für den Kondensator Cs erforderliche Fläche und dessen elektrische Eigenschaften sind Hauptkriterien für die wirtschaftliche Herstellung einer Speichereinheit mit einer Vielzahl von Speicherzellen 200. Auch eine Speichereinheit mit einer Vielzahl von Speicherzellen 200 ist zum Ersetzen eines SRAMS in einer Prozessorspeicherhierarchie geeignet.

Bei einem anderen Ausführungsbeispiel wird an Stelle des FinFET Transistors ein Multi-FinFET Transistor eingesetzt, der an Stelle nur eines Steges eine Vielzahl parallel zueinander angeordneter Stege zwischen seinem Drain-Anschlussbereich und seinem Source-Anschlussbereich enthält.

**Patentansprüche**

1. Integrierte Schaltungsanordnung (120),
   mit einem elektrisch isolierenden Isolierbereich, und mit mindestens einer einen Kondensator (124) bildenden Bereichsfolge, die in der angegebenen Reihenfolge enthält:

   einen isolierbereichsnahen Elektrodenbereich (34),
   einen dielektrischen Bereich (46), und
   einen isolierbereichsfernen Elektrodenbereich (56),wobei der Isolierbereich Bestandteil einer in einer Ebene angeordneten Isolierschicht (14) ist,
   wobei der Kondensator (124) und mindestens ein aktives Bauelement (122) der integrierten Schaltungsanordnung (120) auf der gleichen Seite der Isolierschicht (14) angeordnet sind, und wobei der isolierbereichsnahe Elektrodenbereich (34) und der aktive Bereich (82) des Bauelementes (122) in einer Ebene angeordnet sind, die parallel zu der Ebene liegt, in der die Isolierschicht (14) angeordnet ist,
   wobei das Bauelement mindestens einen Feldeffekttransistor (122) umfasst, dessen Kanalbereich der aktive Bereich ist, wobei der Feldeffekttransistor (122) mindestens einen Steg enthält, wobei mehrere Steuerelektroden (54) an einander gegenüberliegenden Seiten des Steges (30a) angeordnet sind und elektrisch von Kanalbereich (82) durch Steuerelektrodenisolationsbereiche (42, 44) isoliert sind, wobei ein Verbindungsbereich die Steuerelektroden (54) elektrisch verbindet,
   und wobei die Steuerelektroden (54) das gleiche Material wie der isolierbereichsferne Elektrodenbereich (56) enthalten, **dadurch gekennzeichnet, dass** der Verbindungsbereich vom Kanalbereich durch einen dicken Isolierbereich (18, 20) getrennt ist, der eine Isolierstärke hat, die größer als die Dicke der Steuerelektrodenisolationsbereiche (42, 44) ist, und dass der dielektrische Bereich (46) und der isolierbereichsferne Elektrodenbereich (56) an vier oder an fünf Seitenflächen oder an mehr als fünf Seitenflächen des isolierbereichsnahen Elektrodenbereiches (34) angeordnet sind.

2. Schaltungsanordnung (120) nach Anspruch 1, **dadurch gekennzeichnet, dass** der isolierbereichsnahe Elektrodenbereich (34) ein einkristalliner Bereich ist, vorzugsweise ein dotierter Halbleiterbereich,
   und/oder dass der isolierbereichsnahe Elektrodenbereich (34) und/oder der aktive Bereich (82) eine Dicke kleiner als einhundert Nanometer oder kleiner als fünfzig Nanometer hat, und/oder dass der aktive Bereich (82) ein einkristalliner Bereich ist, vorzugsweise ein Halbleiterbereich der dotiert oder undotiert ist.

3. Schaltungsanordnung (120) nach Anspruch 1 oder 2, **dadurch gekennzeichnet, dass** die Isolierschicht (14) an einer Seite an ein Trägersubstrat (12) angrenzt, vorzugsweise an ein Trägersubstrat, das ein Halbleitermaterial enthält oder aus einem Halbleitermaterial besteht, insbesondere aus Silizium oder aus einkristallinem Silizium, und dass die Isolierschicht (14) an der anderen Seite an den isolierbereichsnahen Elektrodenbereich (34) angrenzt, wobei die beim Abgrenzen gebildeten Grenzflächen vorzugsweise vollständig in zwei zueinander parallelen Ebenen liegen, und/oder dass die Isolierschicht (14) ein elektrisch isolierendes Material enthält oder aus einem elektrisch isolierenden Material besteht, vorzugsweise ein Oxid, insbesondere Siliziumdioxid.

4. Schaltungsanordnung (120) nach einem der vorhergehenden Ansprüche, **dadurch gekennzeichnet, dass** der dielektrische Bereich (46) Siliziumdioxid enthält oder aus Siliziumdioxid besteht,
oder dass der dielektrische Bereich (46) aus einem Material mit einer Dielektrizitätskonstante größer als vier oder größer als zehn oder größer als fünfzig besteht.

5. Schaltungsanordnung (120) nach einem der vorhergehenden Ansprüche, **dadurch gekennzeichnet dass** der isolierbereichsferne Elektrodenbereich (56) Silizium enthält, vorzugsweise polykristallines Silizium oder aus Silizium besteht, vorzugsweise aus polykristallinem Silizium,
oder dass der isolierbereichsferne Elektrodenbereich (56) ein Metall enthält oder aus einem Metall besteht,
oder dass der isolierbereichsferne Elektrodenbereich (56) ein niederohmiges Material enthält, vorzugsweise Titannitrid, Tantalnitrid oder Rubidium oder hochdotiertes Siliziumgermanium,
oder dass der isolierbereichsferne Elektrodenbereich (56) an einen Metallhalbleiterverbindungen enthaltenden Bereich angrenzt, insbesondere an einen Silizidbereich (96).

6. Schaltungsanordnung (120) nach einem der vorhergehenden Ansprüche, **dadurch gekennzeichnet, dass** der isolierbereichsnahe Elektrodenbereich (34) eine Vielzahl von Stegen enthält, deren Steghöhe größer als die Stegbreite ist, vorzugsweise mindestens doppelt so groß.

7. Schaltungsanordnung (120) nach einem der vorhergehenden Ansprüche, **gekennzeichnet durch** den mindestens einen Feldeffekttransistor (122), dessen Kanalbereich (82) der aktive Bereich ist, wobei der Kanalbereich (82) undotiert ist,
und/oder dessen Steuerelektrode (54) Material der gleichen Dotierstoffkonzentration wie der isolierbereichsferne Elektrodenbereich (56) enthält,
und/oder dessen Steuerelektrodenisolationsbereich (42, 44) das gleiche Material und/oder ein Material mit der gleichen Dicke wie die der dielektrische Bereich (46) enthält,
und/oder dessen Steuerelektrodenisolationsbereich (42, 44) ein anderes Material und/oder ein Material mit einer anderen Dicke als der dielektrische Bereich (46) enthält.

8. Schaltungsanordnung (120) nach Anspruch 7, **dadurch gekennzeichnet, dass** zwei Steuerelektroden (54) an einander gegenüberliegenden Seiten des Steges (30a) angeordnet sind,
und/oder dass mindestens eine Steuerelektrode (54) an einen Metallhalbleiterverbindungen enthaltenden Bereich angrenzt, insbesondere an einen Silizidbereich (92),
und/oder wobei der Verbindungsbereich aus dem gleichen Material besteht und/oder die gleiche Dotierstärke wie der isolierbereichsferne Elektrodenbereich (56) hat.

9. Schaltungsanordnung (120) nach Anspruch 7 oder 8, **dadurch gekennzeichnet, dass** ein Anschlussbereich oder beide Anschlussbereiche (70, 72) des Feldeffekttransistors (122) an die Isolierschicht (14) grenzen,
und/oder dass mindestens ein Anschlussbereich (70, 72) an einen eine Metallhalbleiterverbindung enthaltenden Bereich angrenzt, vorzugsweise an einen Silizidbereich (90, 94),
und/oder dass die Anschlussbereiche (70, 72) eine größere Dicke haben als der aktive Bereich (82).

10. Schaltungsanordnung (120) nach einem der Ansprüche 7 bis 9, **dadurch gekennzeichnet, dass** beidseitig der Steuerelektroden (54) Abstandshalter (60b, 60c) angeordnet sind, die vorzugsweise ein anderes Material enthalten als die Elektrodenschicht, vorzugsweise Siliziumnitrid, oder die aus einem anderen Material bestehen als die Elektrodenschicht, vorzugsweise aus Siliziumnitrid,
und/oder dass an mindestens einer Seite des isolierbereichsfernen Elektrodenbereiches (56) ein Abstandshalter (60d) angeordnet ist, der ein anderes Material enthält, vorzugsweise Siliziumnitrid, oder aus einem anderen Material besteht als die Elektrodenschicht (50), vorzugsweise aus Siliziumnitrid, und/oder dass sich ein an einer Steuerelektrode (54) des Feldeffekttransistors (122) angeordneter Abstandshalter (60c) und ein an dem isolierbereichsfernen Elektrodenbereich (56) angeordneter Abstandshalter (60d) berühren.

**11.** Schaltungsanordnung (120) nach einem der Ansprüche 7 bis 10, **dadurch gekennzeichnet, dass** ein Anschlussbereich (72) des Feldeffekttransistors (122) und der isolierbereichsnahe Elektrodenbereich (34) des Kondensators (124) aneinander grenzen und eine elektrisch leitfähige Verbindung an der Grenze haben.

**12.** Schaltungsanordnung (120) nach einem der Ansprüche 7 bis 11, **dadurch gekennzeichnet, dass** der an den Elektrodenbereich (34) angrenzende Anschlussbereich (72) nicht an einen eine Metallhalbleiterverbindung enthaltenden Bereich angrenzt, und dass der andere Anschlussbereich (70) an einen eine Metallhalbleiterverbindung enthaltenden Bereich angrenzt.

**13.** Schaltungsanordnung (120) nach Anspruch 11 oder 12, **dadurch gekennzeichnet, dass** die an den Anschlussbereich (72) angrenzende Seite des isolierbereichsnahen Elektrodenbereiches (34) länger ist als eine quer zu dieser Seite liegende Seite des isolierbereichsnahen Elektrodenbereiches (34), vorzugsweise mindestens doppelt so lang oder mindestens fünf mal so lang,
wobei der Transistor (122) vorzugsweise eine Transistorweite hat, die ein mehrfaches der minimalen Strukturbreite (F) beträgt, vorzugsweise mehr als das Dreifache oder mehr als das Fünffache.

**14.** Schaltungsanordnung (120) nach Anspruch 11 oder 12, **dadurch gekennzeichnet, dass** eine quer zu der an den Anschlussbereich (72) angrenzende Seite des isolierbereichsnahen Elektrodenbereiches (34) liegende Seite des isolierbereichsnahen Elektrodenbereiches (34) länger als die an den Anschlussbereich (72) angrenzende Seite ist, vorzugsweise mindestens doppelt so lang oder mindestens fünf mal so lang,
wobei der Transistor (122) vorzugsweise eine Transistorweite hat, die kleiner als das Dreifache der minimalen Strukturbreite (F) ist, vorzugsweise kleiner als das Doppelte der minimalen Strukturbreite (F).

**15.** Schaltungsanordnung (120) nach einem der vorhergehenden Ansprüche, **dadurch gekennzeichnet, dass** die Schaltungsanordnung mindestens einen Prozessor enthält, vorzugsweise einen Mikroprozessor,
und/oder das der Kondensator (124) und das aktive Bauelement (122) eine Speicherzelle (120) bilden, insbesondere in einer dynamischen RAM-Speichereinheit,
und/oder dass eine Speicherzelle entweder den Kondensator (122) und nur den Transistor (122) oder den Kondensator (Cs) und mehr Transistoren als den Transistor (M1 bis M3) enthält, vorzugsweise drei Transistoren (M1 bis M3).

**16.** Verfahren zum Herstellen einer integrierten Schaltungsanordnung (120) mit Kondensator (124) nach einem der vorhergehenden Ansprüche,
bei dem die folgenden Verfahrensschritte ausgeführt werden:

Bereitstellen eines Substrats (10), das einen Isolierbereich (14) aus elektrisch isolierendem Material und eine Halbleiterschicht (16) enthält,
Strukturieren der Halbleiterschicht (16) zur Ausbildung mindestens des isolierbereichsnahen Elektrodenbereiches (34) für den Kondensator und zur Ausbildung mindestens des aktiven Bereiches (82) für den Transistor (122),
nach dem Strukturieren der Halbleiterschicht (16) Erzeugen mindestens einer dielektrischen Schicht (42, 44, 46) welche den dielektrischen Bereich (46) umfasst,
nach dem Erzeugen der dielektrischen Schicht (42, 44, 46) Erzeugen einer Elektrodenschicht (50),
Ausbilden der isolierbereichsfernen Elektrode (56) des Kondensators (124) in der Elektrodenschicht (50),
wobei ein Ausbilden mehrerer Steuerelektroden (54) des Transistors (122) gleichzeitig mit dem Ausbilden des isolierbereichsfernen Elektrodenbereiches (56) erfolgt,

wobei die folgenden Merkmale ausgebildet werden:

der Transistor ist der Feldeffekttransistor (122), dessen Kanalbereich der aktive Bereich ist,
der Feldeffekttransistor (122) enthält mindestens einen Steg, die mehreren Steuerelektroden (54) sind an einander gegenüberliegenden Seiten des Steges (30a) angeordnet, ein Verbindungsbereich verbindet die Steuerelektroden (54) elektrisch,

**dadurch gekennzeichnet, dass** der Verbindungsbereich vom Kanalbereich durch einen dicken Isolierbereich (18, 20) getrennt ist, der eine Isolierstärke hat, die grösser als die Dicke von Steuerelektrodenisolationsbereichen (42, 44) ist, und dass der dielektrische Bereich (46) und der isolierbereichsferne Elektrodenbereich (56) an vier oder an fünf Seitenflächen oder an mehr als fünf Seitenflächen des isolierbereichsnahen Elektrodenbereiches (34) angeordnet sind.

**17.** Verfahren nach Anspruch 16, **gekennzeichnet durch** die Schritte:

Aufbringen mindestens einer Isolierschicht (18, 20) auf die Halbleiterschicht (16) vor dem Strukturieren, vorzugsweise einer Siliziumnitridschicht (18) und/oder einer Oxidschicht (20) mit einer ersten Dicke,
und/oder Dotieren der isolierbereichsnahen Elektrode (34), vorzugsweise vor dem Erzeugen der dielektrischen Schicht (42, 44, 46),
und/oder Erzeugen der dielektrischen Schicht (42, 44, 46) gleichzeitig mit einer dielektrischen Schicht am aktiven Bereich (82) des Transistors (122).

**18.** Verfahren nach Anspruch 16 oder 17, **gekennzeichnet durch** die Schritte:

Erzeugen einer Hilfsschicht (52) nach dem Erzeugen der Elektrodenschicht (50), vorzugsweise einer Hilfsschicht mit einer größeren Dicke als die Oxidschicht (18, 20),
und Strukturieren des isolierbereichsfernen Elektrodenbereiches (56) und/oder der Steuerelektroden (54) des Transistors unter Verwendung der Hilfsschicht (52) als Hartmaske.

**19.** Verfahren nach einem der Ansprüche 16 bis 18, **gekennzeichnet durch** die Schritte:

Aufbringen einer weiteren Hilfsschicht (60) nach dem Strukturieren der Steuerelektroden (54) des Transistors (142), vorzugsweise einer Siliziumnitridschicht,
und vorzugsweise anisotropes Ätzen der weiteren Hilfsschicht (60).

**20.** Verfahren nach Anspruch 18 oder nach Anspruch 19 soweit auf Anspruch 18 rückbezogen, **gekennzeichnet durch** die Schritte:

nochmaliges Strukturieren der Isolierschicht (18, 20), wobei vorzugsweise die Dicke der Hilfsschicht (52) verringert wird und/oder die Hilfsschicht (52) aber nicht vollständig entfernt wird.

**21.** Verfahren nach Anspruch 19 und Anspruch 20, **gekennzeichnet durch** anisotropes Ätzen der weiteren Hilfsschicht (60) nach dem Strukturieren der Isolierschicht (20).

**22.** Verfahren nach einem der Ansprüche 16 bis 21, **gekennzeichnet durch** die Schritte:

Durchführen einer selektiven Epitaxie auf freiliegenden Bereichen aus Halbleitermaterial (16) nach dem Ausbilden des isolierbereichsfernen Elektrodenbereiches (56) und/oder nach dem Strukturieren der Steuerelektroden (54) des Transistors (122).

**23.** Verfahren nach einem der Ansprüche 16 bis 22, **gekennzeichnet durch** Dotieren von Anschlussbereichen (70, 72) des Transistors (122) nach dem Ausbilden des isolierbereichsfernen Elektrodenbereiches (56) und/oder nach dem Strukturieren der Steuerelektroden (54) und vorzugsweise soweit auf Anspruch 22 rückbezogen nach der Epitaxie.

**24.** Verfahren nach einem der Ansprüche 18 bis 23 soweit auf Anspruch 18 rückbezogen, **gekennzeichnet durch** den Schritt:

Entfernen der Hilfsschicht (52), vorzugsweise nach dem Strukturieren der Isolierschicht (18, 20).

**25.** Verfahren nach einem der Ansprüche 18 bis 24 soweit auf Anspruch 18 rückbezogen, **gekennzeichnet durch** Entfernen der Hilfsschicht (52) nach dem Durchführen der selektiven Epitaxie gemäß Anspruch 22 oder Anspruch 23.

**26.** Verfahren nach einem der Ansprüche 16 bis 25, **gekennzeichnet durch** selektive Bildung einer Metallhalbleiterverbindung, insbesondere selektive Silizidbildung, auf der Elektrodenschicht (54) und/oder auf freiliegenden Halbleiterbereichen (16).

**27.** Verfahren nach einem der Ansprüche 16 bis 26, **dadurch gekennzeichnet, dass** der isolierbereichsnahe Elektrodenbereich (34) eine Vielzahl von Stegen enthält.

**Claims**

1. Integrated circuit arrangement (120),
having an electrically insulating insulating region, and having at least one sequence of regions which forms a capacitor (124) and which contains, in the order specified:

    an electrode region (34) near the insulating region,
    a dielectric region (46), and
    an electrode region (56) remote from the insulating region, the insulating region being part of an insulating layer (14) arranged in a plane,
    the capacitor (124) and at least one active component (122) of the integrated circuit arrangement (120) being arranged on the same side of the insulating layer (14), and the electrode region (34) near the insulating region and the active region (82) of the component (122) being arranged in a plane which lies parallel to the plane in which the insulating layer (14) is arranged,
    the component comprising at least one field-effect transistor (122), the channel region of which is the active region, the field-effect transistor (122) containing at least one web, a plurality of control electrodes (54) being arranged at mutually opposite sides of the web (30a) and being insulated electrically from the channel region (82) by control electrode insulation regions (42, 44), a connecting region electrically connecting the control electrodes (54),
    and the control electrodes (54) containing the same material as the electrode region (56) remote from the insulating region, **characterized in that** the connecting region is isolated from the channel region by a thick insulating region (18, 20), which has an insulating thickness which is greater than the thickness of the control electrode insulation regions (42, 44), and **in that** the dielectric region (46) and the electrode region (56) remote from the insulating region are arranged at four or at five side areas or at more than five side areas of the electrode region (34) near the insulating region.

2. Circuit arrangement (120) according to Claim 1, **characterized in that** the electrode region (34) near the insulating region is a monocrystalline region, preferably a doped semiconductor region,
and/or **in that** the electrode region (34) near the insulating region and/or the active region (82) has a thickness of less than one hundred nanometers or less than fifty nanometers,
and/or **in that** the active region (82) is a monocrystalline region, preferably a semiconductor region which is doped or undoped.

3. Circuit arrangement (120) according to Claim 1 or 2, **characterized in that** the insulating layer (14) adjoins, at one side, a carrier substrate (12), preferably a carrier substrate which contains a semiconductor material or comprises a semiconductor material, in particular silicon or monocrystalline silicon,
and **in that** the insulating layer (14) adjoins the electrode region (34) near the insulating region at the other side, the boundary areas formed upon adjoining preferably lying completely in two mutually parallel planes,
and/or **in that** the insulating layer (14) contains an electrically insulating material, or comprises an electrically insulating material, preferably an oxide, in particular silicon dioxide.

4. Circuit arrangement (120) according to one of the preceding claims, **characterized in that** the dielectric region (46) contains silicon dioxide or comprises silicon dioxide,
or **in that** the dielectric region (46) comprises a material having a dielectric constant of greater than four or greater than ten or greater than fifty.

5. Circuit arrangement (120) according to one of the preceding claims, **characterized in that** the electrode region (56) remote from the insulating region contains silicon, preferably polycrystalline silicon, or comprises silicon, preferably polycrystalline silicon,
or **in that** the electrode region (56) remote from the insulating region contains a metal or comprises a metal,
or **in that** the electrode region (56) remote from the insulating region contains a low-impedance material, preferably titanium nitride, tantalum nitride, rubidium or highly doped silicon-germanium,
or **in that** the electrode region (56) remote from the insulating region adjoins a region containing metalsemiconductor compounds, in particular a silicide region (96).

6. Circuit arrangement (120) according to one of the preceding claims,
**characterized in that** the electrode region (34) near the insulating region contains a multiplicity of webs whose web height is larger than the web width, preferably at least twice as large.

7.  Circuit arrangement (120) according to one of the preceding claims, **characterized by** the at least one field-effect transistor (122), whose channel region (82) is the active region, the channel region (82) being undoped,
and/or whose control electrode (54) contains material of the same dopant concentration as the electrode region (56) remote from the insulating region,
and/or whose control electrode insulation region (42, 44) contains the same material and/or a material having the same thickness as that of the dielectric region (46),
and/or whose control electrode insulation region (42, 44) contains a different material and/or a material having a different thickness than the dielectric region (46).

8.  Circuit arrangement (120) according to Claim 7, **characterized in that** two control electrodes (54) are arranged at mutually opposite sides of the web (30a),
and/or **in that** at least one control electrode (54) adjoins a region containing metal-semiconductor compounds, in particular a silicide region (92),
and/or the connecting region comprising the same material and/or having the same doping level as the electrode region (56) remote from the insulating region.

9.  Circuit arrangement (120) according to Claim 7 or 8, **characterized in that** one terminal region or both terminal regions (70, 72) of the field-effect transistor (122) adjoin the insulating layer (14),
and/or **in that** at least one terminal region (70, 72) adjoins a region containing a metal-semiconductor compound, preferably a silicide region (90, 94),
and/or **in that** the terminal regions (70, 72) have a larger thickness than the active region (72).

10. Circuit arrangement (120) according to one of Claims 7 to 9, **characterized in that** spacers (60b, 60c) are arranged on both sides of the control electrodes (54), which spacers preferably contain a different material than the electrode layer, preferably silicon nitride, or which spacers comprise a different material than the electrode layer, preferably silicon nitride, and/or **in that** a spacer (60d) is arranged at at least one side of the electrode region (56) remote from the insulating region, which spacer contains a different material, preferably silicon nitride, or comprises a different material than the electrode layer (50), preferably silicon nitride,
and/or **in that** a spacer (60c) arranged at a control electrode (54) of the field-effect transistor (122) and a spacer (60d) arranged at the electrode region (56) remote from the insulating region touch one another.

11. Circuit arrangement (120) according to one of Claims 7 to 10, **characterized in that** a terminal region (72) of the field-effect transistor (122) and the electrode region (34) of the capacitor (124) which is near the insulating region adjoin one another and have an electrically conductive connection at the boundary.

12. Circuit arrangement (120) according to one of Claims 7 to 11, **characterized in that** the terminal region (72) which adjoins the electrode region (34) does not adjoin a region containing a metal-semiconductor compound,
and **in that** the other terminal region (70) adjoins a region containing a metal-semiconductor compound.

13. Circuit arrangement (120) according to Claim 11 or 12, **characterized in that** that side of the electrode region (34) near the insulating region which adjoins the terminal region (72) is longer than a side of the electrode region (34) near the insulating region which lies transversely with respect to said side, preferably being at least twice as long or at least five times as long,
the transistor (122) preferably having a transistor width which is a multiple of the minimum feature size (F), preferably more than three-fold or more than fivefold.

14. Circuit arrangement (120) according to Claim 11 or 12, **characterized in that** a side of the electrode region (34) near the insulating region which lies transversely with respect to that side of the electrode region (34) near the insulating region which adjoins the terminal region (72) is longer than the side adjoining the terminal region (72), preferably at least twice as long or at least five times as long,
the transistor (122) preferably having a transistor width which is less than three times the minimum feature size (F), preferably less than twice the minimum feature size (F).

15. Circuit arrangement (120) according to one of the preceding claims, **characterized in that** the circuit arrangement contains at least one processor, preferably a microprocessor,
and/or **in that** the capacitor (124) and the active component (122) form a memory cell (120), in particular in a dynamic RAM memory unit,
and/or **in that** a memory cell contains either the capacitor (122) and only the transistor (122) or the capacitor (Cs) and more transistors than the transistor (M1 to M3), preferably three transistors (M1 to M3).

16. Method for fabricating an integrated circuit arrangement (120) with a capacitor (124) according to one of the preceding claims,

in which the following method steps are performed:

provision of a substrate (10) containing an insulating region (14) made of electrically insulating material and a semiconductor layer (16),
patterning of the semiconductor layer (16) in order to form at least the electrode region (34) near the insulating region for the capacitor and in order to form at least the active region (82) for the transistor (122),
after the patterning of the semiconductor layer (16) production of at least one dielectric layer (42, 44, 46) which comprises the dielectric region (46),
after the production of the dielectric layer (42, 44, 46) production of an electrode layer (50),
formation of the electrode (56) of the capacitor (124) which is remote from the insulating region in the electrode layer (50),
a formation of a plurality of control electrodes (54) of the transistor (122) taking place at the same time as the formation of the electrode region (56) remote from the insulating region,

the following features being formed:

the transistor is the field-effect transistor (122),
the channel region of which is the active region,
the field-effect transistor (122) contains at least one web,
the plurality of control electrodes (54) are arranged at mutually opposite sides of the web (30a),
a connecting region electrically connects the control electrodes (54),
**characterized in that** the connecting region is isolated from the channel region by a thick insulating region (18, 20), which has an insulating thickness which is greater than the thickness of control electrode insulation regions (42, 44), and **in that** the dielectric region (46) and the electrode region (56) remote from the insulating region are arranged at four or at five side areas or at more than five side areas of the electrode region (34) near the insulating region.

17. Method according to Claim 16, **characterized by** the following steps:

application of at least one insulating layer (18, 20) to the semiconductor layer (16) prior to patterning, preferably a silicon nitride layer (18) and/or an oxide layer (20) having a first thickness,
and/or doping of the electrode (34) near the insulating region, preferably before the production of the dielectric layer (42, 44, 46),
and/or production of the dielectric layer (42, 44, 46) at the same time as a dielectric layer at the active region (82) of the transistor (122).

18. Method according to Claim 16 or 17, **characterized by** the following steps:

production of an auxiliary layer (52) after the production of the electrode layer (50), preferably an auxiliary layer having a larger thickness than the oxide layer (18, 20),
and patterning of the electrode region (56) remote from the insulating region and/or of the control electrodes (54) of the transistor using the auxiliary layer (52) as a hard mask.

19. Method according to one of Claims 16 to 18, **characterized by** the following steps:

application of a further auxiliary layer (60) after the patterning of the control electrodes (54) of the transistor (142), preferably a silicon nitride layer,
and preferably anisotropic etching of the further auxiliary layer (60).

20. Method according to Claim 18 or according to Claim 19 in so far as reference is made back to Claim 18, **characterized by** the following steps:

repeated patterning of the insulating layer (18, 20), preferably the thickness of the auxiliary layer (52) being reduced and/or the auxiliary layer (52) not being completely removed, however.

**21.** Method according to Claim 19 and Claim 20, **characterized by** anisotropic etching of the further auxiliary layer (60) after the patterning of the insulating layer (20).

**22.** Method according to one of Claims 16 to 21, **characterized by** the following steps:

carrying out of a selective epitaxy on uncovered regions made of semiconductor material (16) after the formation of the electrode region (56) remote from the insulating region and/or after the patterning of the control electrodes (54) of the transistor (122).

**23.** Method according to one of Claims 16 to 22, **characterized by** doping of terminal regions (70, 72) of the transistor (122) after the formation of the electrode region (56) remote from the insulating region and/or after the patterning of the control electrodes (54) and preferably, in so far as reference is made back to Claim 22, after the epitaxy.

**24.** Method according to one of Claims 18 to 23 in so far as reference is made back to Claim 18, **characterized by** the following step:

removal of the auxiliary layer (52), preferably after the patterning of the insulating layer (18, 20).

**25.** Method according to one of Claims 18 to 24 in so far as reference is made back to Claim 18, **characterized by** removal of the auxiliary layer (52) after the carrying out of the selective epitaxy according to Claim 22 or Claim 23.

**26.** Method according to one of Claims 16 to 25, **characterized by** selective formation of a metal-semiconductor compound, in particular selective silicide formation, on the electrode layer (54) and/or on uncovered semiconductor regions (16).

**27.** Method according to one of Claims 16 to 26, **characterized in that** the electrode region (34) near the insulating region contains a multiplicity of webs.

## Revendications

**1.** Circuit (120) intégré,
comprenant une région isolante, isolante du point de vue électrique, et au moins une succession de régions qui forme un condensateur (124) et qui comporte dans l'ordre mentionné :

une région (34) d'électrode proche de la région isolante,
une région (46) diélectrique, et
une région (56) d'électrode éloignée de la région isolante, la région isolante faisant partie d'une couche (14) isolante disposée dans un plan,
dans lequel le condensateur (124) et au moins un composant (122) actif du circuit (120) intégré sont disposés du même côté de la couche (14) isolante et dans lequel la région (34) d'électrode proche de la région isolante et la région (82) active du composant (122) sont disposées dans un plan qui est parallèle au plan dans lequel se trouve la couche (14) isolante,
dans lequel le composant comprend au moins un transistor (122) à effet de champ, dont la région de canal est la région active, le transistor (122) à effet de champ comportant au moins une nervure, plusieurs électrodes (54) de commande étant disposées sur des côtés opposés l'un à l'autre de la nervure (30a) et étant isolées électriquement de la région (82) de canal par des régions (42, 44) d'isolation des électrodes de commande, une région de liaison reliant électriquement les électrodes (54) de commande,
et dans lequel les électrodes (54) de commande contiennent le même matériau que la région (56) d'électrode éloignée de la région isolante,
**caractérisé en ce que** la région de liaison est séparée de la région de canal par une région (18, 20) isolante épaisse, qui a une épaisseur isolante qui est plus grande que l'épaisseur des régions (42, 44) d'isolation des électrodes de commande et **en ce que** la région (46) diélectrique et la région (56) d'électrode éloignée de la région isolante sont disposées sur quatre ou sur cinq surfaces latérales ou sur plus de cinq surfaces latérales de la région (34) d'électrode proche de la région isolante.

**2.** Circuit (120) suivant la revendication 1, **caractérisé en ce que** la région (34) d'électrode proche de la région isolante est une région monocristalline, de préférence une région semiconductrice dopée,

et/ou **en ce que** la région (34) d'électrode proche de la région isolante et/ou la région (82) active a une épaisseur plus petite que cent nanomètres ou plus petite que cinquante nanomètres,

et/ou **en ce que** la région (82) active est une région monocristalline, de préférence une région semiconductrice qui est dopée ou qui n'est pas dopée.

**3.** Circuit (120) suivant la revendication 1 ou 2, **caractérisé en ce que** la couche (14) isolante est voisine d'un côté d'un substrat (12) formant support, de préférence d'un substrat formant support qui contient un matériau semiconducteur ou qui est en un matériau semiconducteur, en étant notamment en silicium ou en silicium monocristallin,

et **en ce que** la couche (14) isolante est voisine de l'autre côté de la région (34) d'électrode proche de la région isolante, les surfaces limites formées à la limite se trouvant de préférence entièrement dans deux plans parallèles l'un à l'autre,

et/ou **en ce que** la couche (14) isolante contient un matériau isolant du point de vue électrique, en contenant de préférence un oxyde, notamment du dioxyde de silicium.

**4.** Circuit (120) suivant l'une des revendications précédentes, **caractérisé en ce que** la région (46) diélectrique contient du dioxyde de silicium ou est en dioxyde de silicium,

ou **en ce que** la région (46) diélectrique est en un matériau ayant une constante diélectrique plus grande que quatre ou plus grande que dix ou plus grande que cinquante.

**5.** Circuit (120) suivant l'une des revendications précédentes, **caractérisé en ce que** la région (56) d'électrode éloignée de la zone isolante contient du silicium, de préférence du silicium polycristallin ou est en silicium, de préférence en silicium polycristallin,

ou **en ce que** la région (56) d'électrode éloignée de la zone isolante contient un métal ou est en un métal,

ou **en ce que** la région (56) d'électrode éloignée de la zone isolante contient un matériau à petite valeur ohmique, de préférence du nitrure de titane, du nitrure de tantale ou du rubidium ou du silicium germanium très dopé,

ou **en ce que** la zone (56) d'électrode éloignée de la zone isolante est voisine d'une région contenant des composés métal semiconducteur, notamment d'une région (96) en siliciure.

**6.** Circuit (120) suivant l'une des revendications précédentes, **caractérisé en ce que** la région (34) d'électrode proche de la région isolante comporte une pluralité de nervures, dont la hauteur est plus grande que la largeur, en étant de préférence au moins deux fois aussi grande.

**7.** Circuit (120) suivant l'une des revendications précédentes, **caractérisé par** le au moins un transistor (122) à effet de champ, dont la région (82) de canal est la région active, la région (82) de canal n'étant pas dopé,

et/ou dont l'électrode (54) de commande contient du matériau en la même concentration de substance de dopage que la région (56) d'électrode éloignée de la région isolante,

et/ou dont la région (42, 44) d'isolation des électrodes de commande contient le même matériau que celui de la région (46) diélectrique et/ou un matériau ayant le même épaisseur que celle de la région (46) diélectrique,

et/ou dont la région (42, 44) d'isolation des électrodes de commande contient un matériau autre et/ou un matériau ayant une épaisseur autre que la région (46) diélectrique.

**8.** Circuit (120) suivant la revendication 7, **caractérisé en ce que** deux électrodes (54) de commande sont disposées sur des faces opposées l'une à l'autre de la nervure (30a),

et/ou **en ce qu'**au moins une électrode (54) de commande est voisine d'une région contenant des composés métal semiconducteur, notamment d'une région (92) en siliciure,

et/ou dans lequel la région de liaison est en le même matériau et/ou a la même intensité de dopage que la région (56) d'électrode éloignée de la zone isolante.

**9.** Circuit (120) suivant la revendication 7 ou 8, **caractérisé en ce qu'**une région de borne ou deux régions (70, 72) de borne du transistor (122) à effet de champ sont voisines de la couche (14) isolante,

et/ou **en ce qu'**au moins une région (70, 72) de borne est voisine d'une région contenant un composant métal semiconducteur, de préférence d'une région (90, 94) en siliciure,

et/ou **en ce que** les régions (70, 72) de borne ont une épaisseur plus grande que la région (82) active.

**10.** Circuit (120) suivant l'une des revendications 7 à 9, **caractérisé en ce que** de part et d'autre des électrodes (54) de commande sont disposés des espaceurs (60b, 60c) qui contiennent de préférence un matériau autre que celui de la couche d'électrode, en étant de préférence en nitrure de silicium, ou qui sont en matériau autre que celui de couche d'électrode, en étant de préférence en nitrure de silicium,

et/ou **en ce que** sur au moins une face de la région (56) d'électrode éloignée de la région isolante est disposé un espaceur (60d) qui contient un matériau autre, de préférence du nitrure de silicium, ou qui est en un matériau autre que celui de la couche (50) d'électrode, en étant de préférence en nitrure de silicium,

et/ou **en ce qu'**un espaceur (60c) disposé sur une électrode (54) de commande du transistor (122) à effet de champ et un espaceur (60d) disposé sur la région (56) d'électrode éloigné de la région isolante se touchent.

11. Circuit (120) suivant l'une des revendications 7 à 10, **caractérisé en ce qu'**une région (72) de borne du transistor (122) à effet de champ et la région (34) d'électrode proche de la région isolante du condensateur (124) sont voisines et ont une liaison conductrice de l'électricité à la limite.

12. Circuit (120) suivant l'une des revendications 7 à 11, **caractérisé en ce que** la région (72) de borne voisine de la région (34) d'électrode n'est pas voisine d'une région contenant un composé métal semiconducteur et **en ce que** l'autre région (70) de borne est voisine d'une région contenant un composé métal semiconducteur.

13. Circuit (120) suivant la revendication 11 ou 12, **caractérisé en ce que** le côté, voisin de la région (72) de borne, de la région (34) d'électrode proche de la région isolante est plus long qu'un côté, perpendiculaire à ce côté, de la région (34) d'électrode proche de région isolante, en en étant de préférence au moins deux fois aussi long ou au moins cinq fois aussi long,

le transistor (122) ayant de préférence une largeur de transistor qui s'élève à plusieurs fois la largeur (F) minimum de détail, de préférence de plus du triple ou de plus du quintuple.

14. Circuit (120) suivant la revendication 11 ou 12, **caractérisé en ce qu'**un côté, transversal au côté, voisin de la région (72) de borne, de la région (34) d'électrode voisine de la région isolante, de la région (34) d'électrode proche de la région isolante est plus long que le côté voisin de la région (72) de borne, en en étant au moins deux fois aussi long ou au moins cinq fois aussi long,

dans lequel le transistor (122) a, de préférence, une largeur de transistor qui est plus petite que le triple de la largeur (F) minimum de détail, en étant de préférence plus que petite que le double de la largeur (F) minimum de détail.

15. Circuit (120) suivant l'une des revendications précédentes, **caractérisé en ce que** le circuit contient au moins un processeur, de préférence un microprocesseur,

et/ou **en ce que** le condensateur (124) et le composant (122) actif forment une cellule (120) de mémoire, notamment dans une unité de mémoire RAM dynamique,

et/ou **en ce qu'**une cellule de mémoire contient soit le condensateur (122) et seulement le transistor (122), soit le condensateur (Cs) et plus de transistors que le transistor (M1 à M3), en contenant de préférence trois transistors (M1 à M3).

16. Procédé de fabrication d'un circuit (120) intégré comprenant un condensateur (124) suivant l'une des revendications précédentes,

on se procure un substrat (10) qui comporte une région (14) isolante en un matériau isolant du point de vue électrique et une couche (16) semiconductrice,

dans lequel on effectue les stades de procédé suivants :

on structure la couche (16) semiconductrice pour former au moins une région (34) d'électrode proche de la région isolante pour le condensateur et pour former au moins la zone (82) active pour le transistor (122),

après la structuration de la couche (16) semiconductrice, on produit au moins une couche (42, 44, 46) diélectrique qui comprend la région (46) diélectrique,

après la production de la couche (42, 44, 46) diélectrique, on produit une couche (50) d'électrode,

on forme des électrodes (56), éloignées de la région isolante, du condensateur (124) dans la couche (50) d'électrode,

une formation de plusieurs électrodes (54) de commande du transistor (122) s'effectuant en même temps que la formation de la région (56) d'électrode éloignée de la zone isolante,

dans lequel on a les caractéristiques suivantes :

le transistor est le transistor (122) à effet de champ, dont la région de canal est la région active,

le transistor (122) à effet de champ comporte au moins une nervure, les plusieurs électrodes (54) de commande sont disposées sur des côtés opposés l'un à l'autre de la nervure (30a),

une région de liaison relie les électrodes (54) de commande du point de vue électrique,

**caractérisé en ce que** la région de liaison est séparée de la région de canal par une région (18, 20) isolante épaisse, qui a une épaisseur d'isolation qui est plus grande que l'épaisseur de régions (42, 44) d'isolation d'électrodes de commande et **en ce que** la région (46) diélectrique et la région (56) d'électrode éloignée de la région isolante est disposée sur quatre ou cinq surfaces latérales ou sur plus de cinq surfaces latérales de la région (34) d'électrode proche de la région isolante.

17. Procédé suivant la revendication 16, **caractérisé par** les stades :

    on dépose au moins une couche (18, 20) isolante sur la couche (16) semiconductrice avant la structuration, de préférence une couche (18) en nitrure de silicium et/ou une couche (20) d'oxyde ayant une première épaisseur, et/ou ou dope les électrodes (34) proches de la région isolante, de préférence avant la production de la couche (42, 44, 46) diélectrique,
    et/ou on produit la couche (42, 44, 46) diélectrique en même temps qu'une couche diélectrique sur la région (82) active du transistor (122).

18. Procédé suivant la revendication 16 ou 17, **caractérisé par** les stades :

    on produit une couche (52) auxiliaire après la production de la couche (50) d'électrode, de préférence une couche auxiliaire ayant une épaisseur plus grande que celle de la couche (18, 20) d'oxyde,
    on structure la région (56) d'électrode éloignée de la région isolante et/ou des électrodes (54) de commande du transistor en utilisant la couche (52) auxiliaire comme masque dur.

19. Procédé suivant l'une des revendications 16 à 18, **caractérisé par** les stades :

    on dépose une autre couche (60) auxiliaire après la structuration des électrodes (54) de commande du transistor, (142) de préférence une couche en nitrure de silicium,
    et de préférence on effectue une attaque anisotrope de l'autre couche (60) auxiliaire.

20. Procédé suivant la revendication 18 ou la revendication 19, dans la mesure où elle se rapporte à la revendication 18, **caractérisé par** les stades :

    on structure encore une fois la couche (18, 20) isolante en diminuant de préférence l'épaisseur de la couche (52) auxiliaire et/ou en éliminant mais pas complètement la couche (52) auxiliaire.

21. Procédé suivant la revendication 19 et la revendication 20, **caractérisé par** une attaque anisotrope de l'autre couche (60) auxiliaire après la structuration de la couche (20) isolante.

22. Procédé suivant l'une des revendications 16 à 21, **caractérisé par** les stades :

    on effectue une épitaxie sélective sur des régions dénudées en matériau (16) semiconducteur après la formation de la région (56) d'électrode éloignée de la région isolante et/ou après la structuration des électrodes (54) de commande du transistor (122).

23. Procédé suivant l'une des revendications 16 à 22, **caractérisé par** un dopage de régions (70, 72) de borne du transistor (122) après la formation de la région (56) électrode éloignée de la région isolante et/ou après la structuration des électrodes (54) de commande et de préférence, dans la mesure où l'on se rapporte à la revendication 22, après l'épitaxie.

24. Procédé suivant l'une des revendications 18 à 23, dans la mesure où elles se rapportent à la revendication 18, **caractérisé par** le stade :

    on élimine la couche (52) auxiliaire, de préférence après la structuration de la couche (18, 20) isolante.

25. Procédé suivant l'une des revendications 18 à 24, dans la mesure où elles se rapportent à la revendication 18, **caractérisé en ce que** l'on élimine la couche (52) auxiliaire après avoir effectué l'épitaxie sélective suivant la revendication 22 ou suivant la revendication 23.

26. Procédé suivant l'une des revendications 16 à 25, **caractérisé par** la formation sélective d'un composé métal semiconducteur, notamment par la formation sélective d'un siliciure, sur la couche (54) d'électrode et/ou sur des régions (16) semiconductrices mises à nu.

27. Procédé suivant l'une des revendications 16 à 26, **caractérisé en ce que** la région (34) d'électrode proche de la région isolante comporte une pluralité de nervures.

FIG 1A

FIG 1B

FIG 2A

FIG 2B

FIG 3A

22
20
18
16
14
12
10
30

FIG 3B

22
20
18
16
14
12
10
30

FIG 4A

40    40    30a
32
20
18
16    40
n++    30b
34
14
12
10

FIG 4B

32
14
12
10

EP 2 169 715 B1

# FIG 5B

30a

44 — 42

14 —

12 —

10 ↙

# FIG 5A

30b

30a — 34

46 — n++

20 —
18 —
16
14 —
12 —

10 ↙

# FIG 6B

50 — n++

14 —

12 —

10 ↙

# FIG 6A

50 —
20 —
18 —
16

n++

n++ — 34

14 —

12 —

10 ↙

FIG 7A

FIG 7B

FIG 8A

FIG 8B

FIG 9B

FIG 9A

FIG 10B

FIG 10A

60

52a

54

n++

14

12

10

52b

56

n++

34

n++

60

16

14

12

10

52a

54

n++

14

12

10

52b

56

n++

34

n++

60d

60c

52a

60b

60a

16

14

12

10

FIG 11A

FIG 11B

FIG 12A

FIG 12B

FIG 13B

FIG 13A

FIG 14B

FIG 14A

FIG 15B

FIG 15A

FIG 16B

FIG 16A

FIG 17

FIG 18

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0709893 A2
- US 20020125536 A1

- JP 05343681 B